# FASCICULE DE BREVET EUROPEEN

(11) **EP 2 829 511 B1**
(45) Date de publication et mention de la délivrance du brevet: **10.06.2020**
(21) Numéro de dépôt: 14177849.8
(22) Date de dépôt: 21.07.2014
(51) Int. Cl.: B81C 1/00

(54) **Dispositif comportant un canal fluidique muni d'au moins un système micro ou nanoélectronique et procédé de réalisation d'un tel dispositif**
Vorrichtung, die einen mit mindestens einem mikro- oder nanoelektronischen System ausgestatteten Fluidkanal umfasst, und Herstellungsverfahren einer solchen Vorrichtung
Device comprising a fluid channel having at least one micro or nanoelectronic system and method for producing such a device

(30) Priorité: 22.07.2013 FR 1357199
(43) Date de publication de la demande: 28.01.2015
(73) Titulaire: Commissariat à l'Énergie Atomique et aux Énergies Alternatives, 75015 Paris (FR)
(72) Inventeur: Ollier, Eric, 38100 Grenoble (FR); Marcoux, Carine, 38500 Voiron (FR)
(74) Mandataire: Brevalex

(56) Documents cités:
- EP-A1- 1 362 827
- WO-A2-2006/078968
- FR-A1- 2 957 535
- US-A1- 2002 022 261
- US-A1- 2004 087 043

## Description

### DOMAINE TECHNIQUE ET ART ANTÉRIEUR

La présente invention se rapporte à un dispositif comportant un canal fluidique muni d'au moins un système micro ou nanoélectronique et à un procédé de réalisation d'un tel dispositif.

Les notions de systèmes microélectroniques ou nanoélectronique intègrent les systèmes microélectromécaniques ou MEMS (microelectromechanical systems en anglais) et les systèmes nanoélectromécaniques ou NEMS (Nanoelectromechanical systems). Par soucis de simplification ils seront nommés dans le reste de la description MEMS et NEMS. Ces systèmes sont aujourd'hui couramment employés dans de nombreux produits. De nouvelles applications apparaissent notamment du fait du développement des NEMS qui offrent de nouveaux avantages grâce à la réduction des dimensions. En particulier, du fait de la grande sensibilité en masse de ce type de systèmes, ils sont d'un grand intérêt pour les capteurs chimiques ou biologiques.

Un NEMS ou un MEMS comporte une partie fixe et au moins une partie suspendue (pouvant être mobile) ou partie sensible par rapport à la partie fixe

Mais pour ces applications en particulier, il est nécessaire de gérer l'exposition de la structure de type MEMS ou NEMS, qui offre des caractéristiques physico-chimiques particulières, à un milieu environnant, en général gazeux ou liquide. Pour cela la structure sensible MEMS ou NEMS est disposée dans un canal fluidique dans lequel s'écoule le milieu et permet la mise en contact du milieu à analyser avec la structure sensible NEMS ou MEMS.

Ces structures sensibles sont reliées à un système électronique d'alimentation et de collecte de signaux par des liaisons électriques, celles-ci reliant la structure au système électronique situé à l'extérieur du canal fluidique.

Le canal fluidique est réalisé en rapportant un capot sur un substrat comportant la ou les structures sensibles. Le capot est scellé de manière étanche sur le substrat et comporte au moins deux ouvertures pour assurer la circulation dans le canal du fluide à analyser. Le capot est formé par une cavité réalisée dans un substrat de plusieurs µm à plusieurs centaines de µm de profondeur par exemple.

Le document WO2011/154363 décrit un dispositif d'analyse, par exemple une microcolonne de chromatographie en phase gazeuse comprenant des MEMS et/ou NEMS dans la microcolonne, formant des capteurs. La connexion des MEMS et/ou NEMS est réalisé par exemple par des vias.

Le scellement du capot peut être de type scellement polymère, scellement moléculaire, scellement anodique, scellement eutectique, frittage verre, etc. Se pose alors le problème de la réalisation des liaisons électriques entre la ou les structures sensibles se trouvant à l'intérieur du canal fluidique et l'extérieur du canal fluidique puisque le scellement, tout en permettant ces liaisons électriques, doit être étanche.

Une technique consiste, après scellement du capot, à ouvrir de larges cavités dans l'épaisseur du capot uniquement au-dessus des zones de plots métallisés pour permettre une reprise de contact directe par wirebonding sur ces plots, chaque plot de contact étant entouré d'un cordon de scellement, par exemple en polymère, pour isoler cette partie de la cavité. Mais cette technique présente l'inconvénient d'introduire des motifs supplémentaires pour ces passages électriques à l'intérieur du canal fluidique ce qui n'est pas souhaitable car ils peuvent être à l'origine de perturbation de la circulation du fluide, de génération de volumes morts, etc. Par ailleurs, cette technique est mal adaptée dans le cas de structures sensibles de type NEMS ou MEMS car ces structures requièrent des plots de contact en matériau semi-conducteur ou en métal de petite taille pour réduire les capacités parasites et être en mesure d'extraire un signal électrique exploitable avec un bon rapport signal/bruit. Enfin cette technique n'est pas adaptée pour des composants formés de NEMS ou MEMS en réseaux, car ceux-ci sont interconnectés entre eux avec une densité importante, ce qui implique la mise en œuvre de plots de très petites tailles, et éventuellement à l'aide de plusieurs niveaux métalliques.

Une autre technique pour réaliser ces connexions électriques tout en assurant l'étanchéité consiste à réaliser des connexions de type Via, par exemple des TSV (Through Silicon Via en anglais) ou TGV (Through Glass Via en anglais). Le document « 3D MEMS high vaccum wafer level packaging - S. Nicolas et al. Electronic Components and Technology Conference (ECTC), 2012 IEEE 62nd, Date of Conference: May 29 2012-June 1 2012*,* décrit de telles réalisations. Par exemple, de telles connexions de type TSV seraient par exemple réalisées dans l'épaisseur du capot et déboucheraient dans la cavité, la continuité électrique étant alors assurée par un plot/cordon métallique à l'intérieur de la cavité. Or de tels via seraient réalisés dans des épaisseurs importantes de matériau semi-conducteur, qui peuvent être de l'ordre de plusieurs centaines de µm, ce qui rend la fabrication de contacts de petite taille très difficile. De plus, la présence de TSV traversant le capot et débouchant dans la cavité fluidique peut perturber le fonctionnement du canal fluidique, par exemple en perturbant la propagation du mélange en circulation, en perturbant les propriétés chimiques des interfaces en contact avec le milieu en circulation du fait des matériaux des TSV.... De plus, compte tenu des dimensions du canal, en particulier de la hauteur de la cavité, la liaison électrique entre le TSV dans le capot et la structure sensible serait difficile à réaliser.

Le document FR2957535 décrit un système microfluidique comportant un substrat et un capot réalisé par surmoulage sur un capteur de débit. Ce système comprend une partie sensible et un canal fluidique défini entre le substrat et le capot, la structure microélectronique étant situé à l'intérieur du canal fluidique.

### EXPOSÉ DE L'INVENTION

C'est par conséquent un but de la présente invention d'offrir un dispositif comportant au moins un canal fluidique, comportant une ou plusieurs structures sensibles situées dans le canal fluidique, et des liaisons électriques entre la ou les structures sensibles situées dans le canal fluidique et l'extérieur du canal fluidique ne présentant pas les inconvénients cités ci-dessus.

C'est également un but d'offrir un procédé de réalisation d'une telle structure à canal fluidique.

Le but mentionné ci-dessus est atteint par une structure comportant un canal fluidique formé par un substrat comprenant au moins une structure sensible, au moins une connexion électrique entre la structure sensible et une zone extérieure au canal fluidique, ladite connexion électrique étant formée sur la surface du substrat portant la structure sensible, une couche intermédiaire recouvrant au moins en partie la connexion électrique, ladite couche intermédiaire présentant une face libre apte au scellement du capot, et un capot scellé de manière étanche sur la face libre plane de la couche intermédiaire.

Dans la présente demande, on entend par "face de la couche intermédiaire apte au scellement", une face présentant un état de surface permettant le scellement avec les faces de base du capot, par exemple un scellement par film sec, un scellement moléculaire, eutectique ou par thermocompression. La face apte au scellement peut présenter une certaine rugosité ou un certain relief qui permet néanmoins le scellement.

La mise en œuvre d'une couche intermédiaire permet la réalisation de lignes de connexion latérale tout en assurant une réalisation simplifiée du scellement étanche entre le capot et le substrat, puisque le scellement est réalisé sur la couche intermédiaire avantageusement plane. En outre la ou les connexions étant réalisées sur la surface du substrat et recouvertes par la couche intermédiaire, elles ne perturbent pas l'écoulement contrairement aux autres solutions mentionnées précédemment, par exemple des TSV réalisés dans le capot.

En d'autres termes, le dispositif à canal fluidique comporte une couche assurant une encapsulation des lignes de connexion au moins dans la zone de scellement avec le capot, cette couche permet alors la libération de la structure NEMS/MEMS tout en conservant une surface permettant le scellement au dessus des lignes de connexion, cette surface étant suffisamment plane pour réaliser un scellement étanche du capot sur la structure NEMS/MEMS.

L'invention permet donc de ne pas recourir à la réalisation de via à travers le capot et/ou à l'ouverture de larges cavités dans l'épaisseur du capot pour permettre une reprise de contact. Le procédé de réalisation est donc sensiblement simplifié.

De manière très avantageuse, cette couche intermédiaire peut être telle qu'elle encapsule les matériaux de la structure NEMS ou MEMS sauf la partie sensible qui, de par leur présence dans le canal fluidique, pourraient interagir avec le milieu en circulation dans le canal, i.e. elle isole les matériaux de la structure NEMS ou MEMS autres que la partie sensible de l'intérieur du canal fluidique. C'est le cas par exemple avec les métaux ou diélectriques qui sont mis en œuvre dans le canal fluidique si la structure mécanique est constituée d'un réseau dense de NEMS. Dans ce cas-là, la couche intermédiaire est uniquement ouverte au niveau des structures NEMS destinées à interagir avec le milieu environnant.

De manière également très avantageuse, la présence de la couche intermédiaire permet la libération des structures mécaniques avant le scellement du capot. Ceci est particulièrement avantageux car on peut envisager des couches de fonctionnalisation des structures mécaniques variées mises en œuvre autrement que par voie liquide. Ces couches de fonctionnalisation sont beaucoup plus compatibles avec des structures mécaniques libérées. Elles peuvent mises en œuvre, par exemple par des dépôts en phase vapeur ou encore par évaporation, par épitaxie ou tout autre de méthode de formation, voire de report de couches. Grâce à l'invention, il est possible de déposer une couche de fonctionnalisation sur la structure NEMS ou MEMS et ainsi de les fonctionnaliser avant de sceller le capot sur le substrat portant les structures mécaniques. Dans ce cas, la couche de fonctionnalisation peut recouvrir entièrement la partie suspendue des structures mécaniques, offrant alors une surface d'interaction augmentée entre l'environnement et la couche de fonctionnalisation.

De manière préférée un film sec de résine est utilisé pour sceller la partie NEMS comportant la couche intermédiaire et le capot.

Par ailleurs, la structure selon l'invention et son procédé de réalisation permet une réalisation collective de puces munies d'un canal fluidique, les puces étant séparées par pré-sciage entre les canaux et prédécoupe transversale aux canaux.

La présente invention a alors pour objet un dispositif comportant un substrat comprenant au moins une structure microélectronique et/ou nanoélectronique comportant au moins une partie sensible et un canal fluidique défini entre ledit substrat et un capot, ledit canal fluidique comportant deux parois latérales et une paroi supérieure raccordant les deux parois latérales et une paroi inférieure formée par ledit substrat et au moins deux ouvertures pour assurer une circulation dans ledit canal, ladite structure microélectronique et/ou nanoélectronique étant située à l'intérieur du canal fluidique, au moins une ligne de connexion électrique s'étendant entre ladite structure microélectronique et/ou nanoélectronique et l'extérieur du canal fluidique, ladite ligne de connexion étant réalisée sur le substrat et passant sous l'une des parois latérales, ledit dispositif comportant également une couche intermédiaire comportant une face en contact avec des faces de base desdites parois latérales, ladite face de la couche intermédiaire présentant une aptitude au scellement avec les faces de base, ladite ligne de connexion étant au moins en partie recouverte par ladite couche intermédiaire au moins à l'aplomb de la face de base de ladite paroi latérale, lesdites parois latérales étant solidarisées de manière étanche sur ledit substrat par scellement sur ladite couche intermédiaire.

Par exemple, le dispositif comportant au moins une paire de lignes de connexion s'étendant latéralement de part et d'autre de la structure microélectronique et/ou nanoélectronique et passant chacune sous une paroi latérale.

Dans un mode de réalisation, la couche intermédiaire recouvre, dans le canal fluidique, toute la structure microélectronique et/ou nanoélectronique à l'exception de sa partie sensible.

La couche intermédiaire peut comporter un matériau isolant électrique, tel qu'un oxyde de silicium, ou un nitrure de silicium.

Dans un mode avantageux, le dispositif comporte une couche de fonctionnalisation encapsulant au moins une partie de la partie sensible de la structure microélectronique et/ou nanoélectronique. La couche de fonctionnalisation peut comporter un ou plusieurs matériaux choisis parmi les matériaux organiques, ou inorganiques, les polymères, les oxydes, les semiconducteurs. La ou les couches de fonctionnalisation peuvent être réalisées par dépôt chimique en phase vapeur, par évaporation, épitaxie, porosification par gravure, dépôt par spray, spotting (dépôt de gouttes), etc. Il est particulièrement intéressant d'utiliser comme couche de fonctionnalisation des matériaux poreux.

Le dispositif peut comporter des lignes de connexion et des plots de contact, lesdits plots de contact étant situés à l'extérieur du canal fluidique, lesdites lignes de connexions s'étendant entre la structure microélectronique et/ou nanoélectronique et les plots de contact.

Dans un exemple de réalisation, les lignes de connexion comportent plusieurs niveaux de métallisation au moins à l'intérieur du canal.

Le scellement peut être réalisé avantageusement au moyen d'un film sec de scellement interposé entre la couche intermédiaire et les faces de base des parois latérales du capot. Le film sec est de manière préférée une résine avec des bases epoxy, phenol, acrylic ou silicone par exemple.

Le film sec de scellement peut être structuré en plusieurs cordons au niveau des interfaces entre la couche intermédiaire et les faces de base des parois latérales. Avantageusement, les cordons sont sensiblement parallèles au canal fluidique.

Le dispositif peut également comporter au moins une couche de matériau interposé entre la couche intermédiaire et les faces de base des parois latérales réalisant un scellement eutectique, par thermo-compression, par sérigraphie ou un scellement par frittage de verre.

Le scellement peut également être un scellement moléculaire, aucune interposition de matériau entre le capot et la couche intermédiaire n'est alors requise.

Dans un exemple de réalisation, la couche intermédiaire comporte une première couche en matériau isolant électrique en contact avec la ligne de connexion et une deuxième couche (déposée sur la première couche, ladite deuxième couche étant en un matériau tel qu'il est peu ou pas sensible à une étape de libération de la structure microélectronique et/ou nanoélectronique. Avantageusement la première couche présente une face plane sur laquelle est déposée la deuxième couche. La deuxième couche est par exemple en Si, en nitrure de silicium, en métal (AISi, AlCu, ...) ou en oxyde d'Hafnium (HfO2)... Cette première couche est avantageusement planarisante.

Le canal forme dans une application très avantageuse une microcolonne de chromatographie en phase gazeuse.

La présente invention a également pour objet un procédé de réalisation d'au moins un dispositif selon l'invention, comportant les étapes :
a) réalisation de la structure microélectronique et/ou nanoélectronique sur un substrat et de la au moins une ligne de connexion,
b) formation de la couche intermédiaire de sorte à ce qu'elle présente une face libre sensiblement plane présentant une ouverture au-dessus de ladite au moins partie sensible
c) réalisation d'un substrat capot, comportant un canal fluidique,
d) scellement du substrat capot sur la couche intermédiaire de sorte que le canal fluidique soit disposé en regard de la structure microélectronique et/ou nanoélectronique.

Lors de l'étape b), la couche est selon un mode avantageux déposée puis structurée pour être éliminée au-dessus de tout ou partie des parties sensibles des structures MEMS/NEMS.

L'étape c) peut-être réalisée à n'importe quel moment du procédé à condition que cela soit avant l'étape d).

Le procédé peut comporter, après l'étape b), une étape de libération de ladite structure microélectronique et/ou nanoélectronique.

Le procédé de réalisation peut également comporter une étape de réalisation d'une couche de fonctionnalisation à l'intérieur du canal fluidique sur la structure microélectronique et/ou nanoélectronique et/ou sur les parois du capot et/ou sur la couche intermédiaire, ladite étape étant effectuée avant le scellement.

En variante, la couche de fonctionnalisation peut être formée avant la libération de la partie sensible, voire avant la formation de la structure sensible.

Des couches de fonctionnalisation à différents emplacements du canal fluidique peuvent être déposées, dans ce cas, ces couches peuvent être de même nature ou non.

Dans un exemple avantageux, l'étape de scellement utilise un film sec, cette étape peut comporter les sous-étapes :
- laminage du film sec sur les faces de base des parois du capot,
- structuration du film sec
- rapprochement du capot et du substrat comportant les structure microélectronique et/ou nanoélectronique,
- application d'une pression de sorte à écraser le film sec.

Un chauffage peut également être appliqué lors de l'application de la pression.

Des préparations de surface peuvent être avantageusement appliquées sur les interfaces avant le scellement par film sec pour améliorer encore l'adhérence, la préparation peut être un traitement de type plasma.

La réalisation de la couche intermédiaire peut avoir lieu par dépôt d'une première couche de matériau isolant électrique et de dépôt d'une deuxième couche sur la première couche.

Le matériau de la deuxième couche est de préférence choisi peu ou pas sensible à l'étape de libération de la structure microélectronique et/ou nanoélectronique, lorsque ce procédé comporte une étape de libération.

Selon un autre exemple de réalisation, le scellement est un scellement eutectique ou par thermo-compression, ou par scellement moléculaire ou par sérigraphie.

La libération peut être obtenue par gravure utilisant l'acide fluorhydrique vapeur.

Lorsque plusieurs dispositifs sont réalisés simultanément, ledit substrat peut comporter plusieurs structures microélectroniques et/ou nanoélectroniques et le substrat capot comportant plusieurs capots, les capots étant scellés simultanément sur le substrat comportant les structures microélectroniques et/ou nanoélectroniques, de sorte qu'un canal fluidique d'un dispositif puisse communiquer ou non avec le canal fluidique d'autres dispositifs.

Lorsque plusieurs dispositifs sont disposés en matrice, les canaux fluidiques de dispositifs en lignes peuvent communiquer entre eux alors que les canaux fluidiques de dispositifs en colonne sont disposés les uns à côtés des autres.

Lorsque plusieurs dispositifs sont réalisés, le procédé de réalisation peut comporter les étapes de :
- de réalisation de prédécoupes dans une direction perpendiculaire aux canaux fluidiques dans le substrat capot et dans le substrat portant les structures microélectroniques et/ou nanoélectroniques,
- de réalisation de découpes ou de prédécoupes dans une direction parallèle aux canaux fluidiques dans le substrat portant les structures microélectroniques et/ou nanoélectroniques,
- de séparation des dispositifs.

Ces découpes partielles ou totales peuvent être obtenues par sciage ou amorphisation laser.

La séparation des dispositifs est réalisée par exemple par clivage.

Le substrat capot peut comporter des cavités formées préalablement entre les canaux dans lesquelles se trouvent les plots de contact après scellement, le procédé peut comporter en outre une étape de découpage du substrat capot pour ouvrir lesdites cavités. Cette étape peut être réalisée avant ou après les découpes ou prédécoupes pour séparer les dispositifs.

Lorsqu'une couche de fonctionnalisation a été formée sur ladite structure microélectronique et/ou nanoélectronique et sur les plots de contact avant le scellement, ledit procédé peut comporter l'étape de retrait par gravure de la couche de fonctionnalisation sur les plots de contact après scellement et ouverture des cavités dans le capot, lesdits capots formant des masques à cette gravure pour les structures microélectroniques et/ou nanoélectroniques.

### BRÈVE DESCRIPTION DES DESSINS

La présente invention sera mieux comprise à l'aide de la description qui va suivre et des dessins en annexes sur lesquels :
- la figure 1A est une vue de dessus d'un dispositif de canal fluidique intégrant des structures MEMS/NEMS avec une couche intermédiaire selon un premier mode de réalisation,
- la figure 1B est une vue agrandie de la figure 1A,
- les figures 2A, 2B, 2B', 2C, 2C' sont des vues en coupe de la figure 1B suivant le plan A-A de différents exemples de réalisation dans lequel le scellement est réalisé au moyen d'un film sec,
- la figure 3A est une vue de dessus d'un dispositif à canal fluidique selon un autre mode de réalisation dans lequel la couche intermédiaire recouvre en partie la structure MEMS/NEMS à l'intérieur du canal, délimitant un canal parallèle au canal fluidique,
- la figure 3B est une vue de dessus d'un dispositif à canal fluidique dans lequel la couche intermédiaire recouvre en partie la structure MEMS/NEMS à l'intérieur du canal, délimitant une fenêtre au niveau de la partie sensible,
- la figure 3C est une vue en coupe de la figure 3A ou de la figure 3B suivant le plan B-B,
- la figure 4A est une vue de dessus d'une variante du dispositif de la figure 3A,
- la figure 4B est une vue en coupe de la figure 4A suivant le plan C-C,
- les figures 5A à 5C sont des vues en coupe transversale d'un dispositif à canal fluidique selon le premier mode de réalisation, présentant d'autres types de scellement et avec ou sans une couche de fonctionnalisation sur la partie MEMS/NEMS,
- les figures 6A à 6L sont des vues schématiques d'un procédé de réalisation du substrat muni d'au moins une structure MEMS ou NEMS pour la réalisation d'un dispositif à canal fluidique selon l'invention,
- les figures 7A à 7C sont des vues schématiques d'un procédé de réalisation d'un capot pour la réalisation d'un dispositif à canal fluidique selon l'invention,
- la figure 8 est une représentation schématique de l'étape d'assemblage du capot de la figure 7C et du substrat de la figure 6K,
- les figures 9A à 9C sont des représentations schématiques de différentes étapes destinées à la séparation des dispositifs à canaux fluidiques dans le cas d'un procédé de réalisation collective des dispositifs.

### EXPOSÉ DÉTAILLÉ DE MODES DE RÉALISATION PARTICULIERS

Dans la présente demande, on entend par partie NEMS/MEMS une structure mécanique comportant une structure fixe et au moins une structure sensible et des moyens d'actionnement et/ou de transduction d'au moins une caractéristique de la structure sensible.

La structure sensible peut être une structure mécanique suspendue et comporter des moyens d'actionnement et/ou de transduction du mouvement mécanique. Des connexions électriques sont prévues pour relier la structure mécanique au milieu extérieur. Cette partie MEMS/NEMS peut comporter un réseau de structures NEMS et/ou MEMS, avec éventuellement plusieurs niveaux de métallisation pour réaliser les interconnexions requises. A des fins de simplicité, un MEMS ou un NEMS sera désigné par NEMS.

Les expressions "partie sensible" et "partie suspendue" seront utilisées indifféremment sachant que dans certaines applications de type électromécanique cette partie sensible est mobile.

Les mêmes références seront utilisées pour désigner les éléments ayant les mêmes fonctions et sensiblement la même forme.

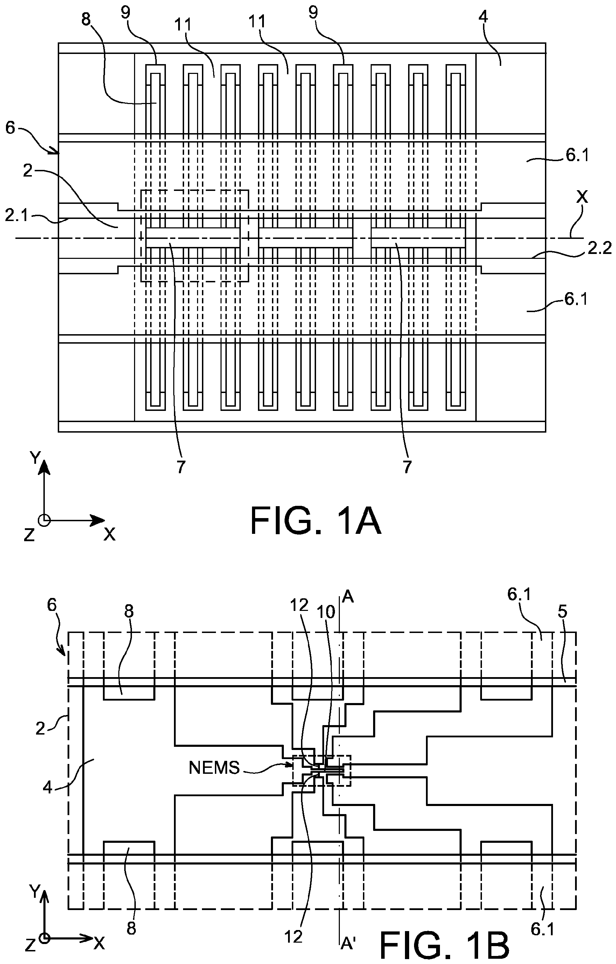

Sur les figures 1A et 1B, on peut voir en vue de dessus représenté de manière schématique un dispositif à canal fluidique selon un premier mode de réalisation, le haut du capot étant omis.

Le dispositif comporte un canal fluidique 2, qui est rectiligne d'axe X dans l'exemple représenté. Le canal fluidique 2 est délimité par un substrat 4 et un capot 6 reporté sur le substrat 4. Par exemple, l'écoulement dans le canal fluidique se fait d'une extrémité longitudinale 2.1 à l'autre 2.2 du canal fluidique 2.

Dans l'exemple représenté, le capot 6 est formé à partir d'un substrat dans lequel une cavité 5 a été ménagée. La cavité 5 délimite avec le substrat portant la structure NEMS/MEMS le canal fluidique 2 qui assure la circulation et la distribution d'un mélange gazeux ou liquide. Le canal est délimité par deux parois latérales 6.1, un fond supérieur 6.2 reliant les deux parois latérales 6.1 et un fond inférieur formé par le substrat 4. Les parois latérales 6.1 présentent des faces de base qui permettent le scellement du capot sur le substrat.

Il sera compris que l'extrémité d'entrée et/ou l'extrémité de sortie du canal fluidique pourraient être par exemple réalisées dans le fond supérieur 6.2 du canal ou encore dans le substrat 4.

Alternativement, le capot 6 pourrait présenter une forme plus complexe, par exemple celui-ci pourrait comporter un long canal de forme optimisée, par exemple en spirale, permettant de réaliser une colonne de chromatographie assurant la fonction de séparation des composés d'un mélange, la colonne intégrant une structure NEMS/MEMS.

Le substrat comporte une structure NEMS/MEMS 7 situé à l'intérieur du canal fluidique 2. Dans l'exemple représenté, la structure NEMS/MEMS comporte trois NEMS alignés le long de l'axe longitudinal X.

Le dispositif comporte également des lignes de connexion électrique 8 s'étendant latéralement entre les NEMS situés dans le canal fluidique 2 et des plots 9 situés à l'extérieur du canal fluidique. Les plots 9 sont par exemple réalisés directement dans le matériau semi-conducteur de la structure NEMS\MEMS. Ils peuvent avantageusement être recouverts de métal pour assurer un bon contact électrique. Les lignes de connexion 8 peuvent être en semi-conducteur dopé du type de celui formant la structure NEMS/MEMS.

Les lignes de connexion 8 sont séparées par des tranchées 11 de sorte à isoler électriquement les lignes de connexion 8 entre elles.

Ces lignes de connexion 8 peuvent être réalisées avec un ou plusieurs niveaux de métal séparés par un matériau diélectrique comme cela sera décrit pas la suite.

Ces lignes peuvent également être réalisées en semi-conducteur recouvert de métal afin de réduite la résistance électrique de la ligne.

En variante, les lignes de connexion peuvent être en métal, le contact entre le semi-conducteur dans lequel est réalisée la structure et le métal étant alors localisé soit dans le canal fluidique, soit à l'extérieur de ce canal, soit éventuellement sous la zone de scellement séparant le canal fluidique de l'extérieur. De manière avantageuse, les lignes de connexion 8 comportent une partie réduite en matériau semi-conducteur seul pour limiter les résistances électriques et les capacités parasites qui peuvent dégrader les performances des composants NEMS.

De préférence, les pistes métalliques pour former les lignes de connexion sont réalisées de façon préférentielle en configuration damascène pour éviter la formation d'interstices ou voids ou de zones de plus faible densité dans le diélectrique de remplissage et dans le matériau de la couche intermédiaire, ce qui est susceptible de conduire à des infiltrations et gravures indésirables lors de l'étape de libération des structures mécaniques, y compris latéralement sous les zones de scellement entre le substrat et le capot. En outre, ils pourraient conduire à des fuites latérales hors du canal fluidique.

Dans l'exemple représenté, trois paires de lignes de connexion électriques 8 s'étendant latéralement de part et d'autre du canal fluidique 2 sont prévues par NEMS.

Un dispositif comportant au moins deux lignes de connexion latérales s'étendant du même côté par rapport à l'axe X ne sort pas du cadre de la présente invention.

Sur la figure 1B, on peut voir une vue agrandie de la figure 1A au niveau d'un NEMS.

Dans l'exemple représenté, la structure suspendue du NEMS est formée par une poutre 10 encastrée à l'une de ses extrémités longitudinales, par exemple deux jauges 12, par exemple piézorésistives, servent à détecter le déplacement de la poutre 10. On peut voir les extrémités des lignes de connexion 8 connectées à la structure NEMS/MEMS.

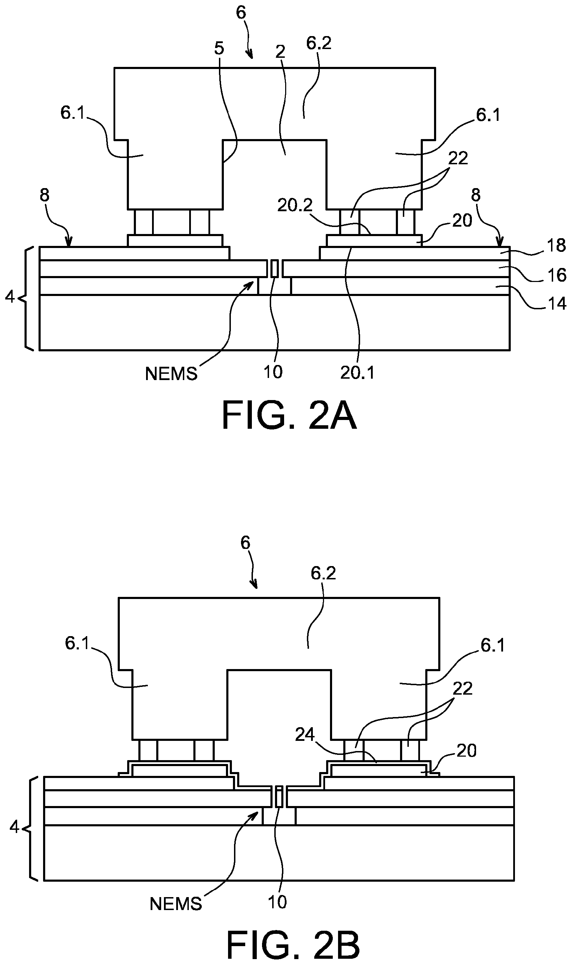

Sur la figure 2A, on peut voir une vue en coupe transversale le long du plan A-A de la figure 1B. Sur cette vue le sommet du capot 6 est représenté.

Le substrat 4 comporte un empilement d'une couche sacrificielle 14 utilisée pour la réalisation du NEMS, d'une couche 16 en semi-conducteur dans laquelle sont réalisées la partie fixe et la partie mobile du NEMS.

Dans cet exemple, les lignes de connexion 8 sont formées à la fois dans la couche 16 et d'une ligne en métal 18 recouvrant la couche 16.

Une couche intermédiaire 20 recouvre au moins partiellement les lignes de connexion 8 et une couche de scellement 22 est disposée entre la couche intermédiaire 20 et le capot 6.

La couche intermédiaire 20 est présente au moins au niveau de l'interface de scellement entre la structure NEMS/MEMS 7 et le capot et est absente des zones de la structure NEMS/MEMS afin de laisser la ou les parties partie de la structure NEMS/MEMS suspendue en contact avec le milieu présent dans le canal fluidique. Dans le premier mode de réalisation représenté sur les figures 1A, 1B, 2A à 2C et 5A à 5C, la couche intermédiaire 20 est localisée uniquement proche de l'interface de scellement entre la structure NEMS/MEMS 7 et le capot 6, et plus particulièrement entre les lignes de connexion 8 et le capot 6.

La couche intermédiaire 20 comporte une première face 20.1 en contact avec les lignes de connexion 8, cette face 20.1 suivant la topologie des lignes de connexion 8 et du substrat 4 et une deuxième face 20.2 en contact avec le capot 6. La couche intermédiaire 20 est telle que la deuxième face 20.2 soit apte à réaliser le scellement du capot 6 comportant la partie NEMS, en assurant à la fois l'étanchéité le long du canal fluidique et le passage des lignes de connexion 8 et ceci de manière simplifiée. La présence de la couche intermédiaire 20 permet de compenser la topologie générée par la formation préalable de la structure NEMS/MEMS et des lignes de connexion 8.

Comme indiqué ci-dessus, la couche intermédiaire 20 permet le passage d'au moins une partie des interconnexions électriques entre l'intérieur du canal fluidique 2 et l'extérieur du canal fluidique 2 tout en assurant une interface de scellement relativement plane facilitant l'obtention d'une étanchéité.

Dans l'exemple représenté, la couche intermédiaire 20 présente des propriétés d'isolation électrique de sorte à isoler électriquement les lignes de connexion 8 entre elles. En outre, son matériau est choisi de sorte à permettre l'obtention d'une face 20.2 suffisamment plane pour le scellement. En fonction du type de scellement, l'état de surface de la face 20.2 obtenu directement après le dépôt de la couche intermédiaire peut être suffisant, ou une étape de planarisation est réalisée par exemple une étape de polissage mécano-chimique après la formation de la couche intermédiaire.

Le matériau de la couche intermédiaire est choisi apte à être gravé, par exemple en gravure anisotrope.

De préférence, le matériau de la couche intermédiaire 20 est choisi de sorte à présenter une bonne sélectivité à la gravure par rapport au procédé de libération des structures mécaniques et à ne pas générer de résidu lors de cette étape.

Le matériau de la couche intermédiaire est également choisi de sorte à être compatible avec les matériaux utilisés pour l'assemblage final du dispositif entre le substrat portant la structure NEMS/MEMS et le capot.

Dans le cas où une couche de fonctionnalisation est mise en œuvre, le matériau de la couche intermédiaire est choisi compatible avec celui de la couche de fonctionnalisation, en particulier de sorte à assurer une bonne adhérence de cette dernière.

Par exemple, le matériau de la couche intermédiaire est un matériau diélectrique, par exemple un oxyde de silicium, comme par exemple le du SiO₂ ou un oxyde formé à base de silane ou un oxyde formé à base de tetraethylorthosilicate (TEOS), un oxyde de silicium de type LTO (Low Temperature Oxyde) formé par dépôt chimique en phase vapeur basse pression ou LPCVD (Low Pressure Chemical Vapor Déposition) non dopé ou bien dopé au phosphore (PSG : phospho-Silicate-Glass) ou encore dopé au Bore et Phosphore (BPSG : Boro-Phospho-Silicate Glass), un oxyde déposé par dépôt chimique en phase vapeur assisté par plasma ou PECVD (Plasma Enhanced Chemical Vapor Déposition).

De manière très avantageuse, la couche intermédiaire 20 comporte plusieurs matériaux présentant chacun des propriétés intervenant dans la réalisation du dispositif. Par exemple, ces matériaux peuvent être disposés en couches successives. Par exemple, la couche intermédiaire comporte deux couches, une première couche déposée sur les lignes de connexion, désignée couche planarisante, qui permet de combler la topologie de la structure NEMS/MEMS et des lignes de connexion tout en assurant l'isolation électrique, et une deuxième couche déposée sur la première couche destinée à accroître la protection de l'ensemble lors de l'étape de libération de la structure mécanique.

La planéité de la couche planarisante assure la planéité de la couche de protection. Ainsi, une plus grande liberté est permise au niveau du choix du matériau pour la couche planarisante. A titre d'exemple, le matériau de la première couche est en oxyde de silicium et le matériau de la deuxième couche est en silicium amorphe ou en tout autre matériau capable de tenir la libération par l'acide fluorhydrique dans le cas ou le couche sacrificielle est en oxyde de silicium, comme un métal, un nitrure de silicium, etc. qui permet de protéger la surface supérieure de la première couche en oxyde lors de la libération.

Cette réalisation en au moins une couche planarisante et une couche de protection est particulièrement intéressante, car les vitesses de gravure des oxydes de silicium formant la couche planarisante sont en général très supérieures, par exemple au moins 10 fois supérieure, à la vitesse de gravure de la couche d'oxyde d'un substrat SOI par exemple qui est effectuée lors de la libération de la ou des structures mobiles. En l'absence d'une telle couche de protection, la gravure de libération de la ou les structures mobiles pourrait occasionner une consommation importante de la couche planarisante. Cette réalisation en deux couches permet donc avantageusement de réduire l'épaisseur de la couche planarisante. Par exemple, son épaisseur peut être de quelques dizaines de nm.

Dans la réalisation où la couche intermédiaire ne comporte qu'un seul matériau son épaisseur est déterminée pour tenir compte de la consommation de matériau lors de la gravure de libération. Dans ce cas, l'épaisseur de la couche intermédiaire est par exemple de l'ordre de quelques µm.

Dans l'exemple des figures 2A à 2C et de manière particulièrement avantageuse, le scellement est réalisé au moyen d'un film de résine sec 22 ou DFR (Dry Film Resist en anglais).

Par exemple, un film mince de résine 22 est appliqué par laminage sur la face inférieure du capot 6 destinée à venir en contact de la couche intermédiaire 20 et est structuré par photolithographie. L'ensemble capot et film de résine, est reporté et scellé sur la couche intermédiaire 20.

Dans l'exemple représenté sur les figures 2A à 2C, le film mince 22 se présente sous la forme de deux cordons parallèles, présentant sensiblement la même surface de scellement. Ces cordons sont obtenus après insolation et développement du film sec.

Le film sec est par exemple une résine avec des bases epoxy, phenol, acrylic ou silicone par exemple.

Le film sec a par exemple une épaisseur comprise entre quelques µm à plusieurs dizaines de µm, voire quelques centaines de µm avec un multicouche de film sec, avantageusement quelques µm seulement pour éviter l'interaction entre le matériau de ce cordon de scellement avec le milieu se propageant dans le canal fluidique.

Le scellement au moyen d'un film sec présente les avantages suivants :
- ce scellement peut avoir lieu à une température relativement basse, généralement en dessous de 250°C voire à température ambiante, ce qui est compatible avec l'existence de pistes métalliques. En effet, dans le cas de pistes en aluminium, la température maximale est d'environ 400°C.
- ce scellement est compatible avec un grand nombre de matériaux,
- le film sec peut être réalisé sur le capot malgré la forte topologie due au canal fluidique déjà formé, ce qui permet de ne pas effectuer des opérations de type photolithographie sur la structure NEMS/MEMS car celle-ci contient déjà des structures mécaniques libérées,
- ce scellement par film sec présente l'avantage d'être moins exigeant en termes d'état de surface nécessaire (planéité, rugosité, présence de particules) à l'interface de scellement que des scellements de type moléculaire ou eutectique ou même par thermo-compression. Ainsi la mise en œuvre d'un film sec peut permettre le scellement sans effectuer de polissage mécano-chimique préalable de la face plane 20.2 de la couche intermédiaire, son état de surface directement après dépôt pouvant être suffisant.

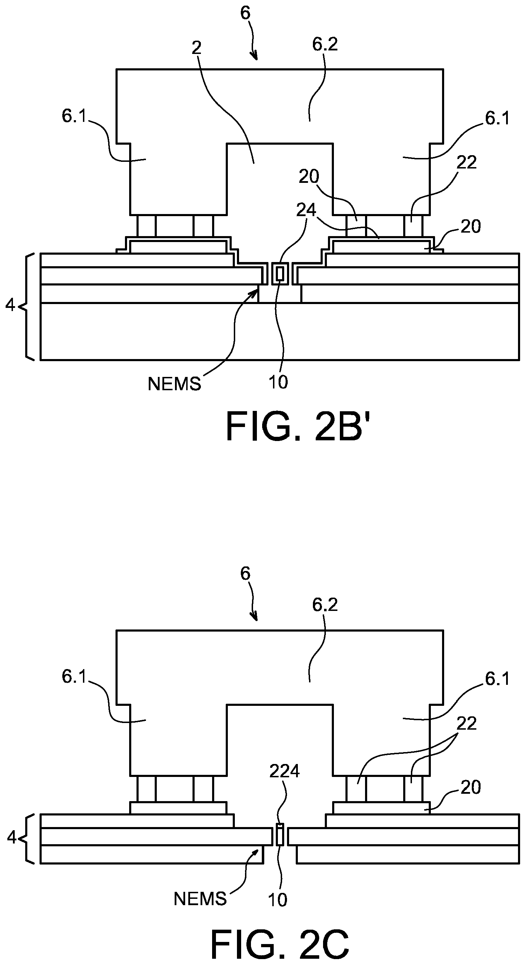

Cette caractéristique permet avantageusement de réaliser ce scellement en présence d'une couche de fonctionnalisation à l'interface de scellement NEMS/Capot comme cela est représenté sur la figure 2B.
- Ce type de film offre en outre la possibilité de travailler avec des épaisseurs importantes, par exemple de l'ordre de plusieurs centaines de µm mais également des épaisseurs de quelques 10µm; voire quelques µm.
- De plus, ce type de film présente une bonne stabilité thermique.

Un scellement par une autre technique ne sort pas du cadre de la présente invention, par exemple il pourrait s'agir d'un scellement moléculaire, d'un scellement eutectique, d'un scellement par thermo-compression, ou d'un scellement par sérigraphie.... Néanmoins, la mise en œuvre de ces techniques pourra se révéler plus complexe que le scellement par film sec. En effet, il sera préférable de limiter les températures mise en œuvre pour ne pas détériorer les pistes métalliques déjà présentes et éventuellement la couche de fonctionnalisation. Par ailleurs, ces températures seront choisies inférieures à environ 400°C pour au moins préserver les couches métalliques des lignes de connexion. Elles seront encore inférieures pour préserver certaines couches de fonctionnalisation par exemple de type polymère.

Dans le cas où le dépôt d'une couche est requis pour le scellement, celle-ci pouvant être éventuellement structurée sur une seule des deux parties, ce qui est le cas pour un scellement eutectique, ce dépôt et cette éventuelle structuration sont effectués de préférence sur le capot. Par exemple pour un eutectique Au-Si, une couche d'Au est déposée de préférence sur le capot.

Dans le cas où le dépôt d'une couche sur chacune des deux parties est requis, par exemple pour un scellement par thermo-compression, le dépôt sur la structure NEMS/MEMS est effectué avant la libération de la structure. Le matériau de cette couche est alors choisi compatible avec le procédé de libération de la structure NEMS/MEMS de sorte qu'elle ne se grave pas lors de cette étape technologique qui intervient juste avant le scellement. On utilisera alors par exemple une couche d'Au sur le capot et sur la couche intermédiaire pour un scellement Au-Au, dans le cas d'une libération des NEMS avec l'acide fluorhydrique en phase vapeur.

Sur la figure 2B, le dispositif comporte une couche de fonctionnalisation 24 recouvrant la couche intermédiaire 20 et toute la structure NEMS/MEMS. Cette couche de fonctionnalisation 24 est dite non localisée. Sur la figure 2B', la couche de fonctionnalisation entoure la structure NEMS.

On entend par "couche de fonctionnalisation" une couche présente à la surface de la structure mécanique pour lui offrir des propriétés particulières. Par exemple dans le cas d'un capteur de gaz, la couche de fonctionnalisation permet d'accroître l'adsorption d'espèces gazeuses de manière éventuellement sélective ou, dans le cas d'un capteur biologique, la couche de fonctionnalisation permet d'assurer le greffage d'espèces biologiques. La couche de fonctionnalisation 24 est par exemple formée d'un ou des plusieurs matériaux organiques ou inorganiques, de polymères, d'oxydes, de composés carbonés, de semi-conducteurs ou autres matériaux poreux...

L'invention permet très avantageusement de réaliser l'étape de dépôt de la couche de fonctionnalisation sur une structure mécanique déjà libérée, ce qui permet d'encapsuler presque totalement la structure mécanique avec la couche de fonctionnalisation (figure 2B') lorsque le dépôt de celle-ci est suffisamment conforme. La couche de fonctionnalisation présente alors une surface d'interaction avec le milieu environnant accrue ce qui augmente encore l'intérêt d'une couche de fonctionnalisation. L''invention permet la mise en œuvre de couches de fonctionnalisation sur des NEMS libérés par des techniques sans contact et collectives, par exemple par dépôt CVD, LPCVD, PECVD, ALD, épitaxie, porosification, etc. et de poursuivre ensuite par la fermeture du composant en rapportant un capot comportant une cavité de manière à former le canal fluidique. Ainsi les risques de collage par dépôt de la couche de fonctionnalisation par dépôt en phase liquide sont évités.

De préférence, le scellement est réalisé au moyen d'un film sec 22 comme décrit ci-dessus, en effet la température d'un tel scellement est compatible avec la présence d'une couche de fonctionnalisation déposée ou formée elle-même à basse température, par exemple en polymère, etc.

Comme cela a été décrit ci-dessus, le scellement par film sec présente l'avantage d'être moins exigeant en termes d'état de surface nécessaire (planéité, rugosité, présence de particules) à l'interface de scellement que des scellements de type moléculaire ou eutectique ou même par thermo-compression. Ainsi il permet un scellement même en présence d'une couche de fonctionnalisation à l'interface de scellement entre la couche intermédiaire et le capot.

En outre, ce scellement étant compatible avec un grand nombre de matériaux, une grande liberté est offerte pour le choix de la ou des couches de fonctionnalisation qui peuvent être mises en œuvre. On peut alors envisager de mettre en œuvre des couches de fonctionnalisation de natures et/ou d'épaisseurs différentes sur les parties NEMS et Capot. Ceci est particulièrement intéressant dans le cas où le capot forme une colonne de chromatographie gazeuse. Dans ce cas le capot pourra recevoir une fonctionnalisation apte à remplir la fonction de séparation des analytes du mélange à analyser alors que le NEMS pourra recevoir une autre fonctionnalisation apte à optimiser ses performances en détection.

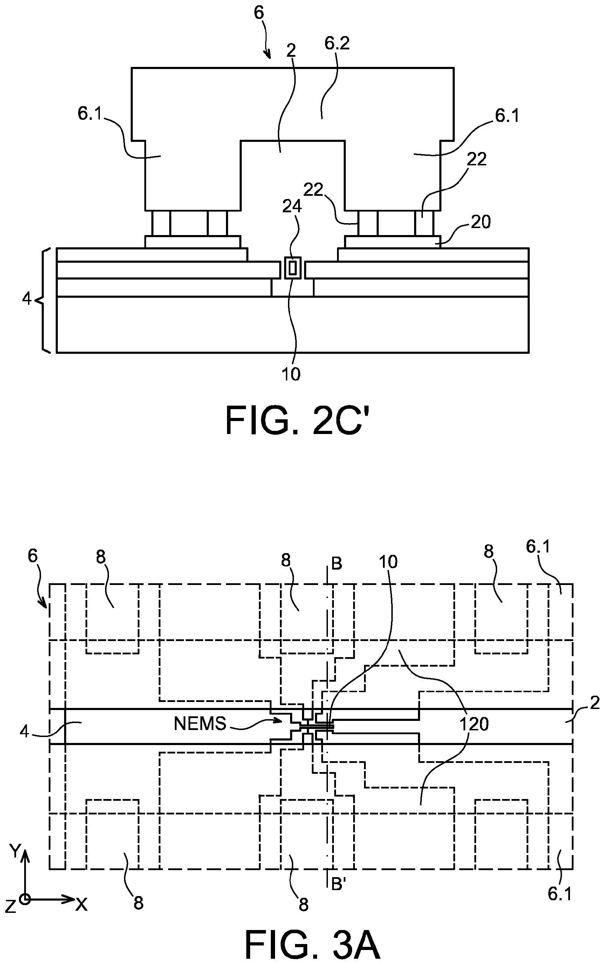

Sur la figure 2C, on peut voir un autre exemple de réalisation dans lequel la couche de fonctionnalisation 224 est réalisée uniquement sur la partie suspendue du NEMS, la couche de fonctionnalisation est alors désignée couche localisée. Dans cet exemple, la couche de fonctionnalisation n'est pas présente au niveau de la zone de scellement. Sur la figure 2C', la couche de fonctionnalisation 224 entoure la structure NEMS.

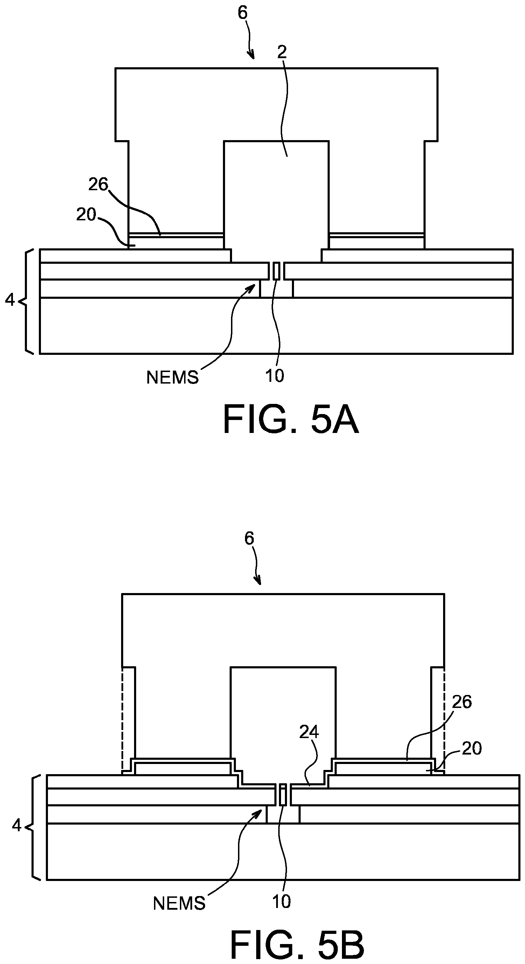

Sur les figures 5A à 5C, on peut voir représentés différents exemples de dispositif selon le premier mode de réalisation dans le cas d'un scellement autre que par film sec. Il sera compris que ces exemples de scellement s'appliquent également aux autres modes de réalisation qui seront décrits ci-dessous. Dans cet exemple les moyens de scellement sont symbolisés par une interface de scellement 26.

Dans le cas d'un scellement moléculaire ou d'un scellement anodique, par exemple dans le cas où le capot est en verre, l'interface de scellement 26 est formée par la face du capot et la face du substrat à sceller.

Aucun ajout de matériau n'est requis. Les faces à venir en contact sont préparés de manière connue par l'homme du métier, par exemple par polissage mécano-chimique (ou CMP (chemical-mechanical polishing) en anglais), i.e. la face 20.2 de la couche intermédiaire et la face inférieure du capot 6.

Un scellement moléculaire en présence d'une couche de fonctionnalisation au niveau de l'interface, la couche de fonctionnalisation étant déposée après libération, est également envisageable.

Dans d'autres modes de scellement, l'interface de scellement est formée d'une couche en un ou plusieurs matériaux, il peut s'agir d'une couche en Au-Si, AIGe ou AuGe... par exemple dans le cas d'un scellement eutectique, de Au-Au, AuSn... par exemple dans le cas d'un scellement par thermo-compression ou de colles dans le cas d'un scellement par sérigraphie.

Sur la figure 5A, le scellement est réalisé par une interface de scellement 26 entre la couche intermédiaire 20 et le capot 6, le dispositif ne comportant pas de couche de fonctionnalisation.

Sur la figure 5B, le dispositif comporte une couche de fonctionnalisation non localisée, le scellement est obtenu au moyen d'une interface de scellement 26 entre la couche de fonctionnalisation 24 et le capot 6.

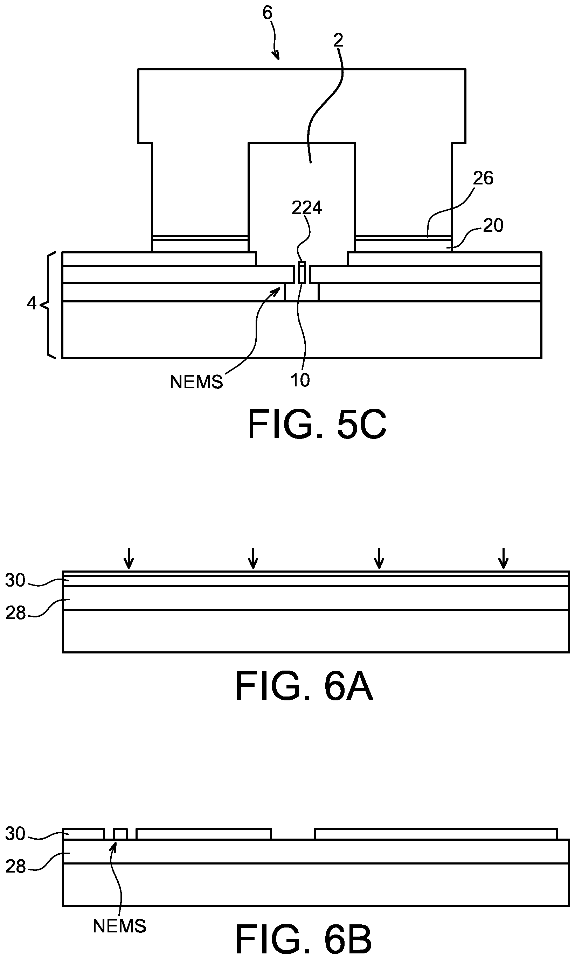

Sur la figure 5C, le dispositif comporte une couche de fonctionnalisation localisée 224 sur la partie suspendue 10, le scellement est obtenu au moyen d'une interface de scellement entre la couche intermédiaire 20 et le capot 6.

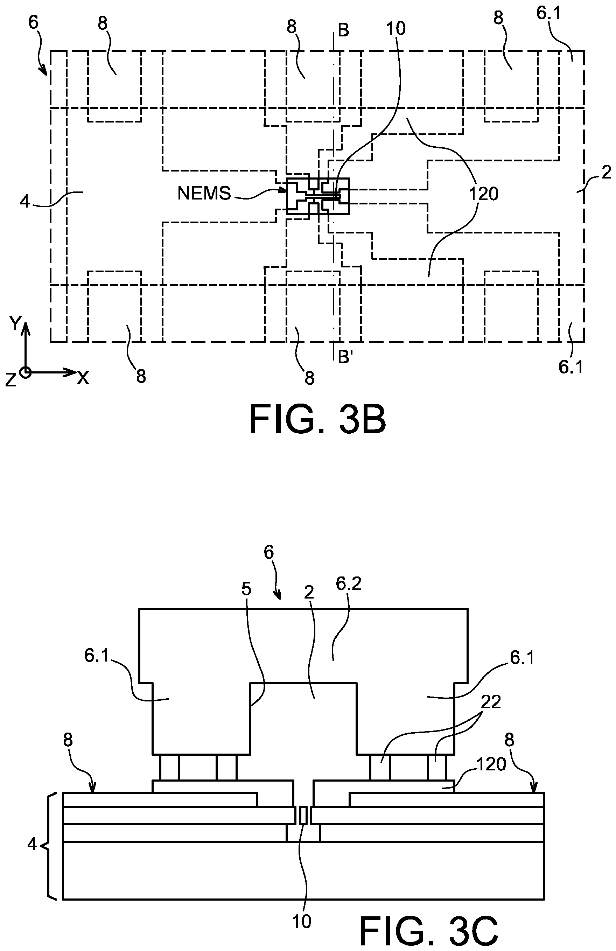

Sur les figures 3A et 3B et 3C, on peut voir un autre mode de réalisation d'un dispositif à canal fluidique selon l'invention dans lequel la couche intermédiaire 120 recouvre à la fois les lignes de connexion au niveau de la zone de scellement mais également l'intérieur du canal fluidique encapsulant ainsi la structure NEMS/NEMS sauf la partie de cette structure destinée à être en contact avec le milieu environnant, i.e. généralement la partie suspendue 10. Dans le dispositif de la figure 3A, la couche intermédiaire 120 est rapprochée au maximum des parties sensibles des structures MEMS/NEMS et forme ainsi un canal sensiblement parallèle au canal fluidique. Dans le dispositif de la figure 3B, la couche intermédiaire 120 recouvre entièrement les structures MEMS/NEMS excepté les parties sensibles et forme ainsi simplement une ouverture au dessus des parties sensibles. La couche intermédiaire 120 encapsule les lignes de connexion 8 entre les différents NEMS du réseau situé dans le canal fluidique 2. Cette encapsulation présente l'avantage d'isoler les matériaux mis en jeu sur la partie NEMS qui, de par leur présence dans le canal fluidique 2, pourraient interagir avec le milieu en circulation dans le canal. C'est le cas par exemple avec les métaux ou diélectriques qui sont en général mis en œuvre dans le canal fluidique si la structure mécanique est constituée d'un réseau dense de NEMS.

Un dispositif à canal fluidique dans lequel la couche intermédiaire ne recouvrirait pas entièrement la partie de la structure NEMS/MEMS non destinée à venir en contact avec le milieu environnant ne sort pas du cadre de la présente invention.

Sur la figure 3C, on peut voir une vue en coupe du dispositif de la figure 3A ou de la figure 3B le long du plan B-B'. Le scellement du capot 6 sur le substrat 4 est obtenu par l'intermédiaire d'un film sec 22 sur la couche intermédiaire 120.

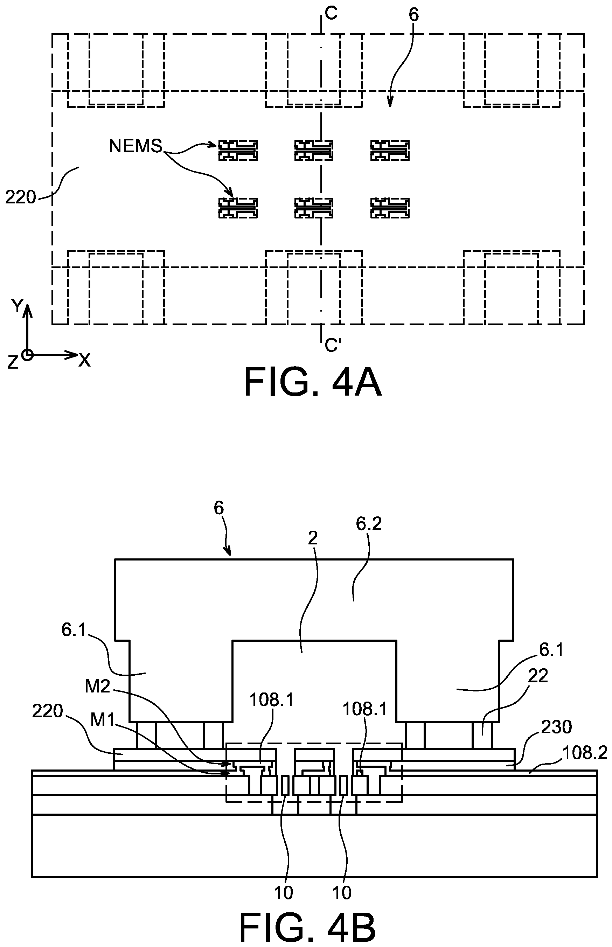

Cette encapsulation par la couche intermédiaire est particulièrement intéressante à mettre en œuvre dans le cas de réseaux de NEMS qui sont connectés entre eux par des pistes conductrices en semi-conducteur ou en métal avec éventuellement plusieurs niveaux d'interconnexions, l'isolation électrique entre les niveaux étant assurée par des couches de diélectriques, et l'ensemble étant localisé dans le canal fluidique. Cet exemple de réalisation est représenté sur les figures 4A et 4B, avec deux niveaux de métal pour les interconnexions entre NEMS situés dans le canal fluidique et un niveau de métal pour la connexion électrique avec l'extérieur du canal fluidique.

Ce dispositif comportant plusieurs NEMS disposés latéralement dans le conduit. Dans l'exemple de la figure 4A, trois paires de NEMS sont alignées le long de l'axe X. Des lignes d'interconnexion 108.1 sont alors réalisées sur plusieurs niveaux de métal, deux dans l'exemple représenté, afin de connecter entre elles les structures NEMS/MEMS constituant le réseau de NEMS, qui se situe à l'intérieur du canal fluidique. Des lignes d'interconnexion 108.2 sont également réalisées (avec un seul niveau dans l'exemple représenté) pour connecter le réseau de NEMS avec l'extérieur du canal fluidique. Ces lignes ne sont pas représentées sur la figure 4A mais le sont sur la figure 4B. Sur la figure 4B, deux parties suspendues sont schématisées, ce qui correspond à une coupe CC' de la structure représentée sur la figure 4A. Les différents niveaux de métallisation sont encapsulés partiellement dans une couche 230 isolant électrique par exemple en oxyde. De manière préférée, les interconnexions 108.1 entre les NEMS comportent deux niveaux de métal et les interconnexions 108.2 pour connecter le réseau de NEMS à l'extérieur du canal fluidique comporte un niveau de métal.

Des interconnexions 108.1 et 108.2 avec un ou plus de deux niveaux de métal ne sortent pas du cadre de la présente invention. Ce dispositif comporte une couche intermédiaire 220 déposée sur les lignes d'interconnexion 108.1 et 108.2 hormis les parties 10 destinées à interagir avec l'environnement environnant.

Nous allons maintenant décrire un exemple de procédé de réalisation de dispositifs à canal fluidique selon la présente invention.

Le procédé qui va être décrit permet la réalisation collective de plusieurs dispositifs simultanément, ceux-ci étant ensuite séparés à la fin du procédé de fabrication. Mais il sera compris que le procédé s'applique à la réalisation d'un seul dispositif à canal fluidique.

Dans une première phase, le substrat muni de la structure NEMS/MEMS est réalisé à partir d'un substrat silicium sur isolant ou SOI (Silicon en Insulator en anglais) par exemple. Alternativement, il peut être utilisé tout substrat comportant une couche dans laquelle serait réalisée la structure NEMS/MEMS, cette couche étant formée sur une couche sacrificielle permettant par sa gravure une libération de la structure NEMS/MEMS. Le matériau de la couche dans laquelle est réalisée la structure NEMS/MEMS peut être un semi-conducteur monocristallin ou polycristallin par exemple du Si, Ge, SiGe, SiC, GAAs, InAs, InP... La couche sacrificielle peut être présente sur l'ensemble du substrat ou bien être localisée seulement à certains endroits où seront réalisés les NEMS.

On peut envisager que la structure NEMS/MEMS comporte une fonction optique de sorte à comporter des microsystèmes opto-électro-mécaniques (ou MOEMS, pour Micro-Opto-Electro-Mechanical Systems en anglais) et/ou d'intégrer une partie électronique intégrée, CMOS, etc.

Le substrat SOI comporte une couche de matériau isolant 28, par exemple de l'oxyde de silicium et une couche de silicium 30.

Lors d'une première étape, le silicium de la couche 30 est dopé.

L'élément ainsi obtenu est représenté sur la figure 6A.

Lors d'une étape suivante, les structures NEMS et les lignes d'interconnexions en semi-conducteur sont réalisées.

Une photolithographie et ensuite une gravure anisotrope de la couche de silicium 30 sont réalisées de manière connue.

Ensuite a lieu une étape de décapage ou stripping sur le silicium et sur la couche d'oxyde 28 pour retirer la couche de résine photosensible.

L'élément ainsi obtenu est représenté sur la figure 6B. Sur la figure 6B qui est une vue en coupe un seul NEMS est visible mais de préférence la structure comporte une pluralité de NEMS dans la direction X. La structure peut également comporter plusieurs NEMS dans la direction Y.

Lors des étapes suivantes, les lignes de connexion en métal sont réalisées. Pour cela, un dépôt d'une couche diélectrique 32 sur la couche 30 structurée a ensuite lieu, il s'agit par exemple d'oxyde formé à base de silane SiH₄ dont l'épaisseur est supérieure à la topologie de la couche de silicium 30 structurée.

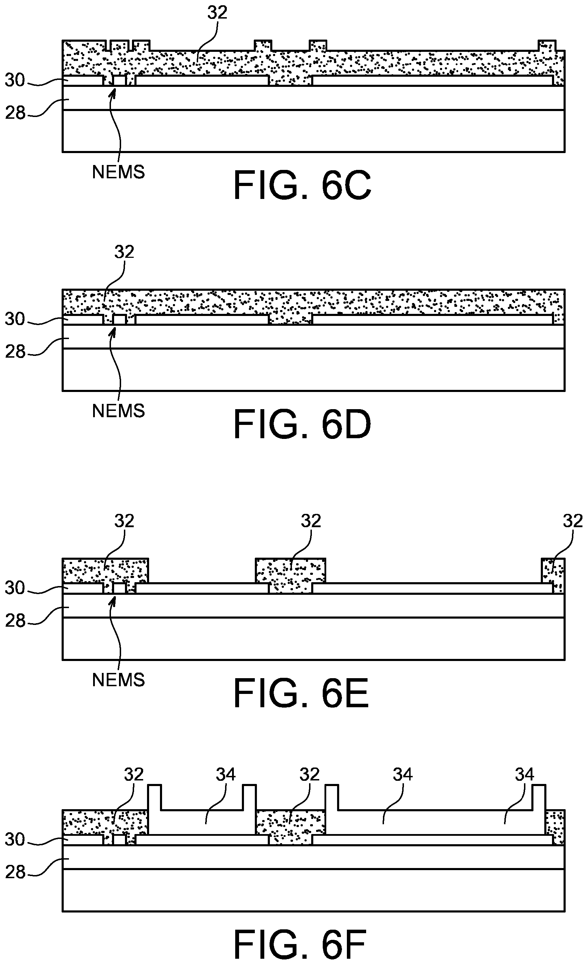

L'élément ainsi obtenu est représenté sur la figure 6C.

Une étape de polissage mécano-chimique ou CMP a ensuite lieu afin de rendre plane la surface de la couche 32. De préférence, préalablement une photolithographie de type "contremasque" et une gravure partielle de la couche 30 de la hauteur de la topologie à rattraper sont effectuées, ce qui facilite l'étape de polissage et permet de réduire sa durée.

L'élément ainsi obtenu est représenté sur la figure 6D.

Lors d'une étape suivante, la couche 32 est ouverte par photolithographie pour atteindre la couche de silicium 30 et préparer la réalisation des contacts électriques.

L'élément ainsi obtenu est représenté sur la figure 6E
Lors d'une étape suivante, une couche de métal 34 est déposée par exemple en AISi, celui-ci présentant l'avantage d'offrir une bonne résistance à la gravure par acide fluorhydrique vapeur qui a lieu pour libérer les structures mécaniques.

Lors d'une étape suivante, la couche 34 métallique est gravée (figure 6F).

Lors d'une étape suivante, a lieu un polissage mécano-chimique.

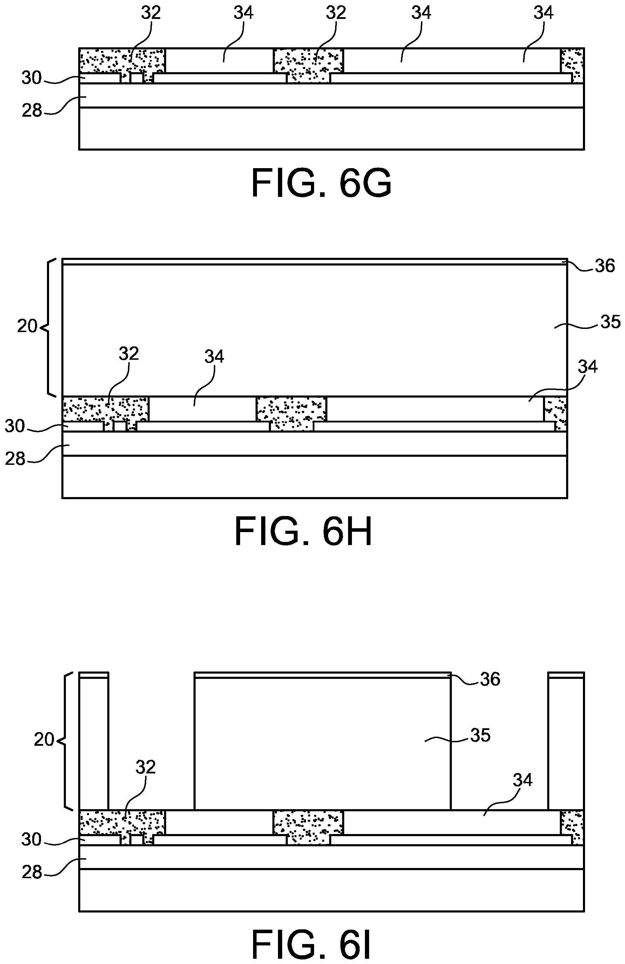

L'élément ainsi obtenu est représenté sur la figure 6G.

Les étapes suivantes décrivent la réalisation de la couche intermédiaire 20.

Dans l'exemple représenté, la couche intermédiaire 20 comporte deux couches. Une couche de matériau diélectrique 35 formant la couche planarisante est déposée. La couche planarisante est par exemple un oxyde formé à base de silane SiH₄, ou encore d'un oxyde formé à base de tetraethylorthosilicate (TEOS). Une couche de protection 36, par exemple en Si amorphe, en nitrure de silicium, en métal (AISi, AlCu, ...), en oxyde d'Hafnium (HfO2), est ensuite déposée sur la couche 35, celle-ci accroissant la résistance à la gravure à l'acide fluorhydrique vapeur.

Dans le cas d'une couche intermédiaire en un seul matériau, son épaisseur est déterminée de sorte qu'elle soit apte à protéger en particulier les lignes de connexion lors de l'étape finale de libération des structures mécaniques, i.e. son épaisseur est choisie suffisante pour tenir compte de sa diminution du fait de la gravure de libération afin qu'elle recouvre encore les lignes de connexion. Comme mentionné précédemment, l'épaisseur de la couche intermédiaire dans ce cas peut être par exemple de l'ordre de quelques µm.

Du fait des CMP réalisées préalablement et en particulier de la CMP réalisée préalablement sur la couche 34, l'état de la surface de la couche intermédiaire permet un scellement par film sec sans recourir à un polissage ultérieur. Une étape de polissage peut être réalisée, notamment dans le cas d'un scellement moléculaire.

L'élément ainsi obtenu est représenté sur la figure 6H.

Lors d'une étape suivante, la couche intermédiaire est gravée de sorte à atteindre la structure NEMS/MEMS à libérer. Par exemple on pourra utiliser une gravure plasma à base de SF₆ pour la couche de Si amorphe et une gravure plasma à base de CHF₃ pour la gravure de l'oxyde de silicium formant la couche intermédiaire.

La gravure de la couche intermédiaire 20 est adaptée pour préserver à la fois les interconnexions métalliques et la structure NEMS/MEMS en matériau semi-conducteur. Ainsi, la forme des ouvertures est déterminée par exemple par photolithogravure de façon à tenir compte de la longueur de libération des structures mécaniques qui intervient en fin de procédé « NEMS », car cette étape peut provoquer une gravure latérale non désirée de la couche planarisante de la couche intermédiaire 20, ce qui, si elle n'était pas maitrisée, pourrait conduire à dégager des zones non désirées telles que des interconnexions métalliques, zones sous l'interface de scellement avec le capot. De plus, la gravure de l'ouverture dans la couche intermédiaire est de préférence stoppée au niveau de la couche métallique au-dessus du semi-conducteur, avant d'atteindre le semi-conducteur, afin de ne pas endommager la couche de semi-conducteur qui constitue la structure mécanique. Sur la figure 6I, on peut voir l'arrêt de la gravure au dessus de la structure.

L'élément ainsi obtenu est représenté sur la figure 6I.

Lors d'une étape suivante, la structure NEMS/MEMS, en particulier la ou les partie mobile est/sont libérée(s). La libération a lieu par exemple par gravure isotrope au moyen d'acide fluorhydrique vapeur des matériaux diélectriques entourant la structure NEMS, il s'agit des couches 28 et 32. La couche 28 peut être gravée totalement ou partiellement. Du fait de la présence de la couche de protection 36, la couche 35 est protégée, son épaisseur ne diminue pas. En revanche est schématisé la gravure latérale de la couche planarisante 35, la couche 36 n'étant, quant à elle, pas gravée.

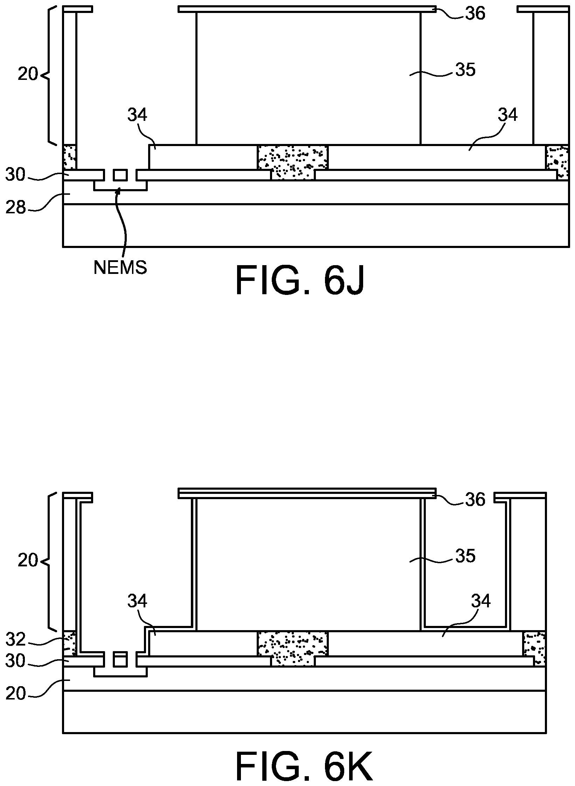

L'élément ainsi obtenu est représenté sur la figure 6J.

Sur la figure 6K, est représenté l'élément de la figure 6J comportant une couche de fonctionnalisation non localisée sur la partie suspendue du NEMS. Il s'agit ici de représenter la réalisation d'une structure du type de celle représentée sur la figure 2B.

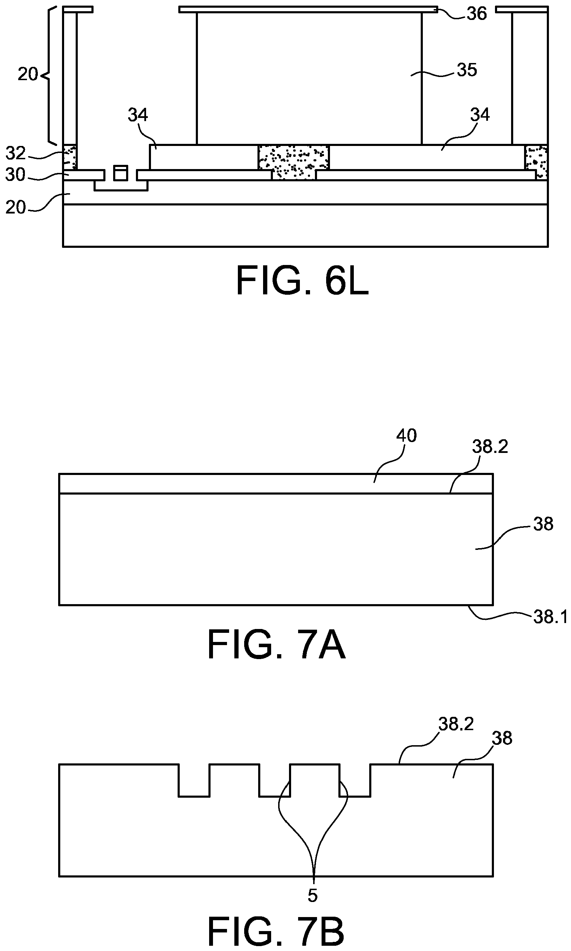

Sur la figure 6L, est représenté l'élément de la figure 6J comportant une couche de fonctionnalisation localisée sur la partie suspendue du NEMS. Il s'agit ici de représenter la réalisation de la structure représentée sur la figure 2C.

Ces couches de fonctionnalisation peuvent être réalisées de différentes manières par dépôts en phase liquide ou gazeuse. De manière préférentielle, des techniques de dépôt en phase gaz par exemple par dépôt chimique en phase vapeur ou CVD (Chemical Vapor Deposition en terminologie anglo-saxonne), par LPCVD, par PECVD, par dépôt de couches minces atomiques ou ALD (Atomic Layer Déposition), etc. sont utilisées. Des techniques d'épitaxie et/ou de porosification de matériaux et/ou de type évaporation peuvent également être mises en œuvre. Ces techniques sont préférables aux techniques par voie liquide, type spray ou spotting (dépôt de gouttes), car elles permettent d'éviter la mise en œuvre de phases liquides en présence de structures NEMS libérées. Néanmoins, ces techniques peuvent également être utilisées, par exemple si les structures NEMS/MEMS sont suffisamment rigides.

Les matériaux déposés formant le ou les couches de fonctionnalisation peuvent être par exemple des matériaux de type polymères, des diélectriques, des semi-conducteurs ou autres matériaux poreux, des métaux, etc.

Dans le cas d'un dépôt localisé, il peut être utilisé des techniques de masquage mécanique (pochoir), des techniques de lift-off connues dans les procédés de réalisation des microsystèmes, ou bien encore des techniques de spotting consistant à déposer des gouttes de solution liquide localement, etc.

Sur la figure 6K, la couche de fonctionnalisation est représentée uniquement en surface du NEMS. Préférentiellement, la couche de fonctionnalisation entoure le NEMS, l'épaisseur de la couche de fonctionnalisation n'étant pas forcément uniforme tout autour de la structure mécanique. Ce dépôt est obtenu en mettant en œuvre des techniques de dépôt conforme, par exemple par CVD.

Un exemple d'étapes de réalisation du capot 6 va maintenant être décrit à partir d'un substrat 38 poli sur ses deux faces, par exemple en silicium, en verre, en quartz..., désigné substrat capot 38.

Tout d'abord, des marques (non représentées) sont définies puis gravées en face arrière 38.1 et en face avant 38.2 du substrat, ces marques servant à l'alignement entre le substrat NEMS et le capot lors de leur scellement.

Lors d'une étape suivante, un dépôt d'un masque dur, par exemple d'un masque d'oxyde de silicium de quelque µm d'épaisseur, est effectué sur la face avant 38.2 du substrat 38 (figure 7A). Une photolithographie et une gravure du masque 40 ont lieu pour définir les cavités.

Ensuite, le substrat capot 38 est gravé par exemple par gravure ionique réactive profonde ou DRIE (Deep reactive ionic etching en anglais) avec par exemple un procédé de type « Bosch » consistant en une succession d'étapes de gravure avec un plasma SF6 et de passivation avec un plasma C4F8 formant ainsi les cavités qui délimiteront les canaux fluidiques. La profondeur de la gravure est par exemple de l'ordre de quelques centaines de µm. Cette gravure permet également avantageusement de réaliser des cavités (non représentées) destinées à se positionner au-dessus des plots électriques après assemblage avec le substrat de la structure NEMS/MEMS, ceci dans le cas particulier où plusieurs dispositifs sont réaliser collectivement, ces cavités permettant la séparation des dispositifs, comme cela sera décrit ci-dessous.

Le masque dur peut ensuite être retiré par exemple par gravure humide de type HF.

L'élément ainsi obtenu est représenté sur la figure 7B et comporte une pluralité de capots 6.

Lors d'une étape suivante, le substrat capot 38 est préparé pour un scellement sur la structure NEMS/MEMS au moyen d'un film sec.

Le film sec 42 est ensuite fixé sur la face avant 38.2 du substrat capot 38, cette fixation est avantageusement obtenue par laminage. Ce laminage permet de travailler malgré la forte topologie due à l'existence des canaux fluidiques de ce côté du substrat.

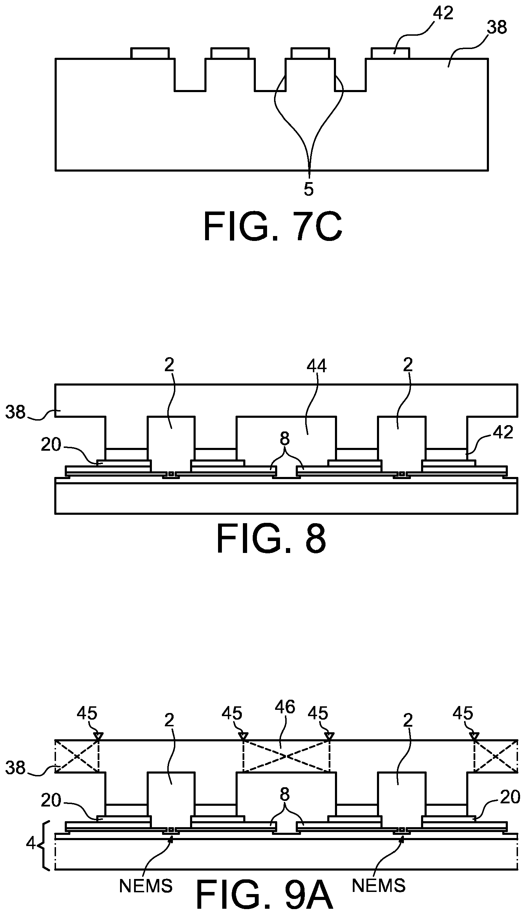

Lors d'une étape suivante, une lithographie et un développement sont réalisés pour structurer le film sec, celui-ci présente alors des cordons le long des cavités gravés dans le capot. Il peut s'agir d'un cordon large tel que cela est représenté sur la figure 7C, ou alors de préférence de plusieurs cordons étroits parallèles les uns aux autres comme cela est représenté sur les figures 2A à 2C. Dans ce dernier cas, par exemple les cordons et les espaces entre les cordons peuvent être de quelque µm à quelques dizaines de micromètres.

De préférence, les cordons présentent une structure régulière et une surface de scellement proche sur l'ensemble de la structure à sceller de sorte à assurer un écrasement homogène du film sec avec une pression raisonnable lors de l'étape de scellement.

L'élément ainsi obtenu est représenté sur la figure 7C, le substrat capot 38 est alors prêt à être scellé sur le substrat de la structure NEMS/MEMS 4.

Sur la figure 8, on peut voir l'étape de scellement du substrat capot 38 et du substrat 4 comportant la structure NEMS/MEMS. Sur ce schéma et les suivants concernant l'assemblage des deux substrats et la séparation des éléments dans le cas d'une fabrication collective, une couche de fonctionnalisation à la surface du NEMS (localisée ou non) n'est pas mise en œuvre, mais si une telle couche de fonctionnalisation localisée ou non était mise en œuvre, le procédé de réalisation serait le même.

Le scellement est réalisé sur un équipement de scellement qui permet de contrôler la température et la pression appliquée entre le capot et le substrat à sceller.

Des traitements de surface connus dans l'état de l'art peuvent éventuellement être effectués pour optimiser l'énergie de collage.

Lors de cette étape, on réalise le scellement de plusieurs capots 6 sur un substrat comportant plusieurs structures NEMS/MEMS.

Tout d'abord, le substrat 4 et le substrat capot 38 sont alignés au moyen des marques réalisées précédemment sur les substrats.

Puis une pression est appliquée entre le substrat 4 et le substrat capot 38, ainsi qu'une température.

Par exemple la pression appliquée est de l'ordre de quelques kN à quelques dizaines de kN, et par exemple la température est comprise entre 100°C et 200°C.

Le substrat 4 et le substrat capot 38 sont alors assemblés. Les canaux fluidiques sont alors étanches au niveau des bords latéraux des canaux. L'élément ainsi obtenu et représenté sur la figure 8 comporte une pluralité de dispositifs à canaux fluidiques.

Typiquement, un assemblage tel que celui de la figure 8 est réalisé à partir de substrats circulaires utilisés en microélectronique.

Les étapes de séparation de ces canaux vont maintenant être décrites. Dans le cas de figure où un seul dispositif aurait été réalisé, le dispositif à canal fluidique serait achevé.

Le procédé de séparation comporte tout d'abord une étape destinée à dégager les plots de contact électrique. D'après le procédé de fabrication décrit ci-dessus et comme on peut le voir sur la figure 8 et la figure 9A, les plots de contact d'un dispositif situés d'un côté du canal 6 sont adjacents à ceux du dispositif voisin situés d'un côté du canal du dispositif voisin.

Ces plots se retrouvent donc dans une même cavité 44 du substrat capot 38.

L'étape de dégagement des plots est donc destinée à déboucher dans les cavités 44 recevant les plots. Cette étape est désignée STR pour Saw To Reveal en anglais.

Cette étape comporte le découpage du substrat du capot localement au droit des plots de contact de sorte à déboucher dans les cavités 44. Les traits de découpe 45 sont symbolisés par les traits interrompus, les découpes délimitant des portions découpées 46 qui sont retirées.

Ce découpage est réalisé dans les plans XZ, ainsi les résidus de sciage ne pénètrent pas dans les canaux.

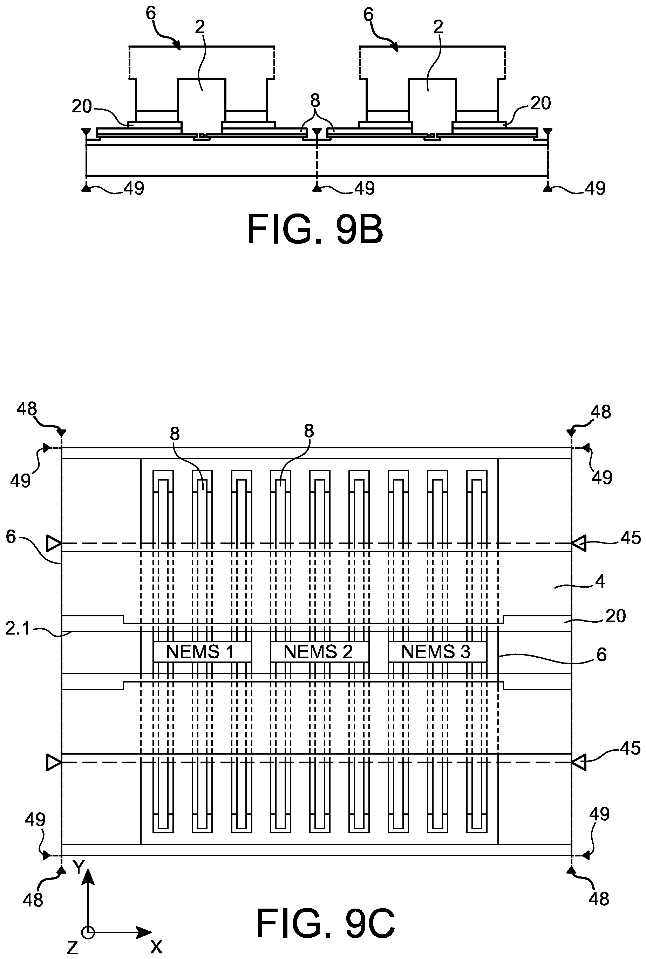

L'élément ainsi obtenu est représentée sur la figure 9B et la figure 9C. Les capots sont désormais séparés les uns des autres. A noter pour la compréhension que sur la figure 9C les puces adjacentes à la puce représentée sur la figure ne sont pas indiquées.

Dans le cas où une couche de fonctionnalisation aurait été déposée de manière non localisée et recouvrirait les plots de contact situés dans les cavités 44, il est possible après retrait des portions de substrat 46 de graver la partie de la couche de fonctionnalisation qui recouvre les plots de contact. Cette gravure utilise de manière particulièrement avantageuse les capots comme masque, assurant ainsi une gravure limitée aux plots de contact; la partie de la couche de fonctionnalisation située sur les structures NEMS/MEMS étant protégée par les capots.

Ensuite est réalisée une étape de prédécoupe de chaque capot et du substrat 4 dans des plans YZ suivant une direction perpendiculaire la direction X des canaux fluidiques uniquement de sorte à séparer longitudinalement les dispositifs à canaux fluidiques.

Ces zones de prédécoupe sont symbolisées par les flèches 48 sur la figure 9C.

De plus des traits de découpe ou de prédécoupe sont également réalisés dans le substrat 4 dans des plans XZ parallèles à la direction X des canaux fluidiques de façon à séparer transversalement les dispositifs à canaux fluidiques.

Ces zones de découpe ou prédécoupe sont symbolisées par les flèches 49 sur la figure 9B.

Ensuite, les dispositifs à canaux fluidiques sont séparés en utilisant les motifs de prédécoupe 48 et 49, par exemple clivage, découpe laser. De préférence, le sciage est évité pour ce qui concerne la réalisation des motifs 48 qui risquerait de polluer l'intérieur des canaux fluidiques.

Cette technique de séparation est particulièrement avantageuse puisqu'elle permet de révéler les plots de contacts électriques tout en éliminant en fin de procédé de fabrication une éventuelle couche de fonctionnalisation présente sur la surface de ces plots. De plus, elle permet de séparer les puces les unes des autres en préservant l'intégrité du canal fluidique.

On pourrait envisager d'utiliser d'autres techniques pour révéler les plots de contacts électriques. Par exemple, on pourrait envisager une gravure du substrat capot 38 jusqu'aux plots ou jusqu' à une cavité formée préalablement au-dessus du plot de contact. Le substrat peut ne pas comporter de cavité 44 dans le cas où on grave le substrat 38 jusqu'aux plots de contact. Mais, de préférence, on prévoit des cavités 44 comme sur la figure 8, la gravure étant arrêtée dés que l'on débouche dans les cavités, ce qui permet de révéler les contacts. Un polissage du substrat capot peut avoir lieur jusqu'à déboucher dans des cavités formées préalablement au-dessus des plots de contact, technique désignée "grinding to reveal" en anglais. Dans ce cas là il convient d'avoir réaliser des cavités du type 44 plus profondes que les cavités des canaux fluidiques pour déboucher dans les cavités 44 sans déboucher dans les canaux fluidiques afin de préserver leur intégrité.

Grâce à l'invention, il est possible de réaliser un dispositif à canal fluidique comportant une ou plusieurs structures mécaniques suspendues dans le canal et une ou plusieurs connexions électriques latérales avec une étanchéité assurée, évitant ainsi la formation de TSV dans le substrat et aussi d'éviter la présence dans le canal fluidique de structures assurant le contact électrique entre la structure mécanique se trouvant à l'intérieur du canal et l'extérieur de ce canal, du type pilier en métal prolongeant des TSV réalisés dans le capot ou du type colonne en Si ou verre avec une cavité gravée à l'intérieur permettant le wire-bonding sur un plot de la structure mécanique isolé de la cavité, comme cela est réalisé classiquement avec des approches de scellement métallique ou polymère. De plus, l'invention permet de réaliser facilement des réseaux de structures mécaniques en permettant une interconnexion électrique dense et complexe au plus près des structures mécaniques avec éventuellement plusieurs niveaux de métal. L'invention peut permettre également d'encapsuler toutes les structures et couches présentes dans le canal exceptées les structures sensibles. Enfin elle permet la mise en œuvre de fonctionnalisation en cours de procédé sur des structures mécaniques suspendues.

## Revendications

1. Dispositif comportant un substrat comprenant au moins une structure microélectronique et/ou nanoélectronique (NEMS) comportant au moins une partie suspendue et un canal fluidique (2) défini entre ledit substrat et un capot (6), ledit canal fluidique (2) comportant deux parois latérales (6.1)et une paroi supérieure (6.2) raccordant les deux parois latérales (6.1) formées par ledit capot et une paroi inférieure formée par ledit substrat et au moins deux ouvertures pour assurer une circulation dans ledit canal, ladite structure microélectronique et/ou nanoélectronique étant située à l'intérieur du canal fluidique, au moins une ligne de connexion électrique (8) s'étendant entre ladite structure microélectronique et/ou nanoélectronique et l'extérieur du canal fluidique (2), ladite ligne de connexion (8) étant réalisée sur le substrat (4) et passant sous l'une des parois latérales (6.1), ledit dispositif comportant également une couche intermédiaire (20) comportant une face en contact avec des faces de base desdites parois latérales (6.1), ladite face de la couche intermédiaire présentant une aptitude au scellement avec les faces de base, ladite ligne de connexion (8) étant recouverte par ladite couche (20) intermédiaire au moins à l'aplomb de la face de base de ladite paroi latérale (6.1), lesdites parois latérales (6.1) étant solidarisées de manière étanche sur ledit substrat (4) par scellement sur ladite couche intermédiaire (20).

2. Dispositif selon la revendication 1, comportant une couche de fonctionnalisation (24, 224) encapsulant au moins une partie de la partie suspendue de la structure microélectronique et/ou nanoélectronique, la couche de fonctionnalisation (24, 224) comportant avantageusement un ou plusieurs matériaux choisis parmi les matériaux organiques, ou inorganiques, les polymères, les oxydes, semi-conducteurs.

3. Dispositif selon la revendication 1 ou 2, comportant au moins une paire de lignes de connexion (8) s'étendant latéralement de part et d'autre de la structure microélectronique et/ou nanoélectronique et passant chacune sous une paroi latérale (6.1).

4. Dispositif selon la revendication 1, 2 ou 3, dans laquelle la couche intermédiaire (20) recouvre, dans le canal fluidique (2), toute la structure microélectronique et/ou nanoélectronique à l'exception de sa partie suspendue.

5. Dispositif selon l'une des revendications 1 à 4, comportant des lignes de connexion (8) et des plots de contact (9), lesdits plots de contact (9) étant situés à l'extérieur du canal fluidique (2), lesdites lignes de connexions (8) s'étendant entre la structure microélectronique et/ou nanoélectronique et les plots de contact (9).

6. Dispositif selon l'une des revendications 1 à 5, dans lequel les lignes de connexion (8) comportent plusieurs niveaux de métallisation au moins à l'intérieur du canal fluidique.

7. Dispositif selon l'une des revendications 1 à 6, comportant un film sec de scellement (22) interposé entre la couche intermédiaire (20) et les faces de base des parois latérales (6.1) du capot, le film sec de scellement (22) étant avantageusement structuré en plusieurs cordons au niveau des interfaces entre la couche intermédiaire et les faces de base des parois latérales.

8. Dispositif selon l'une des revendications 1 à 7, comportant au moins une couche de matériau interposée entre la couche intermédiaire (20) et les faces de base des parois latérales (6.1) réalisant un scellement eutectique ou par thermo-compression, ou par sérigraphie, un scellement moléculaire ou un scellement par frittage de verre.

9. Dispositif selon l'une des revendications 1 à 8, dans lequel la couche intermédiaire (20) comporte une première couche (35) en matériau isolant électrique en contact avec la ligne de connexion (8) et une deuxième couche (36) déposée sur la première couche, ladite deuxième couche (36) étant en un matériau tel qu'il est peu ou pas sensible à une étape de libération de la structure microélectronique et/ou nanoélectronique, la deuxième couche (36) étant avantageusement en Si, en nitrure de silicium, en métal ou en oxyde d'Hafnium.

10. Dispositif selon l'une des revendications 1 à 9, dans lequel le canal forme une microcolonne de chromatographie en phase gazeuse.

11. Procédé de réalisation d'au moins un dispositif selon l'une des revendications 1 à 10, comportant les étapes :
a) réalisation de la structure microélectronique et/ou nanoélectronique sur un substrat et de la au moins une ligne de connexion,
b) formation de la couche intermédiaire de sorte à ce qu'elle présente une face libre sensiblement plane présentant une ouverture au-dessus de ladite au moins partie suspendue
c) réalisation d'un substrat capot comportant un canal fluidique,
d) scellement du substrat capot sur la couche intermédiaire de sorte que le canal fluidique soit disposé en regard de la structure microélectronique et/ou nanoélectronique.

12. Procédé de réalisation selon la revendication 11, comportant une étape de réalisation d'une couche de fonctionnalisation à l'intérieur du canal fluidique sur la structure microélectronique et/ou nanoélectronique et/ou sur les parois du capot et/ou sur la couche intermédiaire ladite étape étant effectuée avant le scellement.

13. Procédé de réalisation selon la revendication 11 ou 12, comportant près l'étape b), une étape de libération de ladite structure microélectronique et/ou nanoélectronique.

14. Procédé de réalisation selon l'une des revendications 11 à 13, dans lequel l'étape de scellement utilisant un film sec, le procédé de réalisation comporte les sous-étapes :
- laminage du film sec sur les faces de base des parois du capot,
- structuration du film sec,
- rapprochement du capot et du substrat comportant les structure microélectronique et/ou nanoélectronique,
- application d'une pression de sorte à écraser le film sec, et/ou dans lequel le scellement est un scellement eutectique ou par thermo-compression, ou par scellement moléculaire ou par sérigraphie.

15. Procédé de réalisation selon l'une des revendications 11 à 14, dans lequel la réalisation de la couche intermédiaire a lieu par dépôt d'une première couche de matériau isolant électrique et de dépôt d'une deuxième couche sur la première couche.

16. Procédé de réalisation selon l'une des revendications 11 à 15, dans lequel plusieurs dispositifs étant réalisés simultanément, ledit substrat comportant plusieurs structures microélectroniques et/ou nanoélectroniques et le substrat capot comportant plusieurs capots, les capots étant scellés simultanément sur le substrat comportant les structures microélectroniques et/ou nanoélectroniques , de sorte qu'un canal fluidique d'un dispositif puisse communiquer ou non avec le canal fluidique d'autres dispositifs.

17. Procédé de réalisation selon la revendication 16, comportant les étapes de :
- de réalisation de prédécoupes dans une direction perpendiculaire aux canaux fluidiques dans le substrat capot et dans le substrat portant les structures microélectroniques et/ou - de réalisation de découpes ou de prédécoupes dans une direction parallèle aux canaux fluidiques dans le substrat portant les structures microélectroniques et/ou nanoélectroniques,
- de séparation des dispositifs, ladite séparation étant avantageusement réalisée par clivage.

18. Procédé de réalisation selon la revendication 16 ou 17, dans lequel le substrat capot comportant des cavités formées préalablement entre les canaux dans lesquelles se trouvent les plots de contact après scellement, le procédé comporte en outre une étape de découpage du substrat capot pour ouvrir lesdites cavités.

19. Procédé de réalisation selon la revendication 18, dans lequel une couche de fonctionnalisation a été formée sur ladite structure microélectronique et/ou nanoélectronique et sur les plots de contact avant le scellement, ledit procédé comportant l'étape de retrait par gravure de la couche de fonctionnalisation sur les plots de contact après scellement et ouverture des cavités dans le capot, lesdits capots formant des masques à ladite gravure pour les structures microélectroniques et/ou nanoélectroniques.

## Patentansprüche

1. Vorrichtung mit einem Substrat, das mindestens eine mikroelektronische und/oder nanoelektronische Struktur (NEMS) mit mindestens einem abgehängten Abschnitt und einen zwischen dem Substrat und einer Abdeckung (6) definierten Fluidkanal (2) aufweist, wobei der Fluidkanal (2) zwei Seitenwände (6.1) und eine obere Wand (6.2), die die beiden von der Abdeckung gebildeten Seitenwände (6.1) verbindet, und eine untere Wand, die von dem Substrat gebildet wird, sowie mindestens zwei Öffnungen zum Sicherstellen einer Strömung in dem Kanal aufweist, wobei sich die mikroelektronische und/oder nanoelektronische Struktur innerhalb des Fluidkanals befindet, wobei mindestens eine elektrische Verbindungsleitung (8) zwischen der mikroelektronischen und/oder nanoelektronischen Struktur und dem Außenbereich des Fluidkanals (2) verläuft, wobei die Verbindungsleitung (8) auf dem Substrat (4) ausgebildet ist und unter einer der Seitenwände (6.1) verläuft, wobei die Vorrichtung ferner eine Zwischenschicht (20) umfasst, die eine Fläche in Kontakt mit den Basisflächen der Seitenwände (6.1) aufweist, wobei die Fläche der Zwischenschicht die Fähigkeit zur Versiegelung mit den Basisflächen aufweist, wobei die Verbindungsleitung (8) mit der Zwischenschicht (20) mindestens in Höhe der Basisfläche der Seitenwand (6.1) bedeckt ist, wobei die Seitenwände (6.1) durch Ansiegeln an der Zwischenschicht (20) in abgedichteter Weise fest mit dem Substrat (4) verbunden sind.

2. Vorrichtung nach Anspruch 1,
enthaltend eine Funktionalisierungsschicht (24, 224), die mindestens einen Teil des abgehängten Abschnitts der mikroelektronischen und/oder nanoelektronischen Struktur einkapselt, wobei die Funktionalisierungsschicht (24, 224) vorteilhafterweise ein oder mehrere Materialien enthält, die aus organischen oder anorganischen Materialien, Polymeren, Oxiden, Halbleitern ausgewählt sind.

3. Vorrichtung nach Anspruch 1 oder 2,
enthaltend mindestens ein Paar von Verbindungsleitungen (8), die sich seitlich auf beiden Seiten der mikroelektronischen und/oder nanoelektronischen Struktur erstrecken und jeweils unter einer Seitenwand verlaufen (6.1).

4. Vorrichtung nach Anspruch 1, 2 oder 3,
wobei die Zwischenschicht (20) in dem Fluidkanal (2) die gesamte mikroelektronische und/oder nanoelektronische Struktur mit Ausnahme ihres abgehängten Abschnitts bedeckt.

5. Vorrichtung nach einem der Ansprüche 1 bis 4,
enthaltend Verbindungsleitungen (8) und Kontaktstücke (9), wobei sich die Kontaktstücke (9) außerhalb des Fluidkanals (2) befinden und die Verbindungsleitungen (8) zwischen der mikroelektronischen und/oder nanoelektronischen Struktur und den Kontaktstücken (9) verlaufen.

6. Vorrichtung nach einem der Ansprüche 1 bis 5,
wobei die Verbindungsleitungen (8) zumindest innerhalb des Fluidkanals mehrere Metallisierungsebenen aufweisen.

7. Vorrichtung nach einem der Ansprüche 1 bis 6,
enthaltend einen trockenen Versiegelungsfilm (22), der zwischen der Zwischenschicht (20) und den Basisflächen der Seitenwände (6.1) der Abdeckung angeordnet ist, wobei der trockene Versiegelungsfilm (22) an den Grenzflächen zwischen der Zwischenschicht und den Basisflächen der Seitenwände vorteilhaft in mehrere Stränge strukturiert ist.

8. Vorrichtung nach einem der Ansprüche 1 bis 7,
enthaltend zumindest eine Materialschicht, die zwischen der Zwischenschicht (20) und den Basisflächen der Seitenwände (6.1) angeordnet ist und eine eutektische Versiegelung, eine Versiegelung durch Thermokompression oder durch Siebdruck, eine molekulare Versiegelung oder eine Glassinterversiegelung bildet.

9. Vorrichtung nach einem der Ansprüche 1 bis 8,
wobei die Zwischenschicht (20) eine erste Schicht (35) aus elektrisch isolierendem Material in Kontakt mit der Verbindungsleitung (8) und eine zweite Schicht (36), die auf die erste Schicht aufgebracht ist, enthält, wobei die zweite Schicht (36) aus einem Material besteht, das so beschaffen ist, dass es geringfügig oder nicht empfindlich gegenüber einem Schritt des Freisetzens der mikroelektronischen und/oder nanoelektronischen Struktur ist, wobei die zweite Schicht (36) vorteilhaft aus Si, Siliziumnitrid, Metall oder Hafniumoxid besteht.

10. Vorrichtung nach einem der Ansprüche 1 bis 9,
wobei der Kanal eine Gaschromatographie-Mikrosäule bildet.

11. Verfahren zum Herstellen zumindest einer Vorrichtung nach einem der Ansprüche 1 bis 10, umfassend die Schritte:
a) Herstellen der mikroelektronischen und/oder nanoelektronischen Struktur auf einem Substrat und Herstellen der zumindest einen Verbindungsleitung,
b) Ausbilden der Zwischenschicht derart, dass sie eine im Wesentlichen ebene Freifläche aufweist, die eine Öffnung unterhalb des zumindest einen abgehängten Abschnitts aufweist,
c) Herstellen eines Abdeckungssubstrats, das einen Fluidkanal aufweist,
d) Ansiegeln des Abdeckungssubstrats an die Zwischenschicht, derart, dass der Fluidkanal der mikroelektronischen und/oder nanoelektronischen Struktur gegenüberliegend angeordnet ist.

12. Herstellungsverfahren nach Anspruch 11,
umfassend einen Schritt des Herstellens einer Funktionalisierungsschicht innerhalb des Fluidkanals an der mikroelektronischen und/oder nanoelektronischen Struktur und/oder an den Wänden der Abdeckung und/oder an der Zwischenschicht, wobei dieser Schritt vor dem Versiegeln erfolgt.

13. Herstellungsverfahren nach Anspruch 11 oder 12,
umfassend nach Schritt b) einen Schritt des Freisetzens der mikroelektronischen und/oder nanoelektronischen Struktur.

14. Herstellungsverfahren nach einem der Ansprüche 11 bis 13,
wobei bei dem Schritt der Versiegelung ein Trockenfilm verwendet wird, wobei das Herstellungsverfahren die folgenden Unterschritte umfasst:
- Auflaminieren des Trockenfilms auf die Basisflächen der Wände der Abdeckung,
- Strukturieren des Trockenfilms,
- Zusammenführen der Abdeckung und des Substrats, welches die mikroelektronischen und/oder nanoelektronischen Strukturen aufweist,
- Aufbringen von Druck, um den Trockenfilm zusammenzudrücken, und/oder
wobei die Versiegelung eine eutektische Versiegelung oder eine Versiegelung durch Thermokompression oder eine molekulare Versiegelung oder eine Versiegelung durch Siebdruck ist.

15. Herstellungsverfahren nach einem der Ansprüche 11 bis 14,
wobei das Ausbilden der Zwischenschicht durch Aufbringen einer ersten Schicht aus elektrisch isolierendem Material und durch Aufbringen einer zweiten Schicht auf die erste Schicht erfolgt.

16. Herstellungsverfahren nach einem der Ansprüche 11 bis 15,
wobei mehrere Vorrichtungen gleichzeitig hergestellt werden, wobei das Substrat mehrere mikroelektronische und/oder nanoelektronische Strukturen enthält und wobei das Abdeckungssubstrat mehrere Abdeckungen aufweist, wobei die Abdeckungen gleichzeitig an das Substrat, das die mikroelektronischen und/oder nanoelektronischen Strukturen enthält, angesiegelt werden, so dass gegebenenfalls ein Fluidkanal einer Vorrichtung mit dem Fluidkanal anderer Vorrichtungen kommunizieren kann.

17. Herstellungsverfahren nach Anspruch 16,
umfassend die folgenden Schritte:
- Herstellen von Vorzuschnitten in einer Richtung senkrecht zu den Fluidkanälen im Abdeckungssubstrat und in dem Substrat, das die mikroelektronischen und/oder nanoelektronischen Strukturen trägt, und/oder
- Herstellen von Zuschnitten oder Vorzuschnitten in einer Richtung parallel zu den Fluidkanälen in dem Substrat, das die mikroelektronischen und/oder nanoelektronischen Strukturen trägt,
- Trennen der Vorrichtungen, wobei dieses Trennen vorteilhaft durch Spaltung erfolgt.

18. Herstellungsverfahren nach Anspruch 16 oder 17,
wobei das Abdeckungssubstrat Hohlräume aufweist, die zuvor zwischen den Kanälen gebildet werden und in denen sich die Kontaktstücke nach dem Versiegeln befinden, wobei das Verfahren ferner einen Schritt des Zuschneidens des Abdeckungssubstrats zum Öffnen der Hohlräume umfasst.

19. Herstellungsverfahren nach Anspruch 18,
wobei bei Ausbilden einer Funktionalisierungsschicht an der mikroelektronischen und/oder nanoelektronischen Struktur und an den Kontaktstücken vor dem Versiegeln das Verfahren den Schritt des Entfernens der Funktionalisierungsschicht an den Kontaktstücken durch Ätzen nach dem Versiegeln und Öffnen der Hohlräume in der Abdeckung umfasst, wobei die Abdeckungen Masken für das Ätzen für die mikroelektronischen und/oder nanoelektronischen Strukturen bilden.

## Claims

1. Device comprising a substrate comprising at least one microelectronic and/or nanoelectronic structure (NEMS) comprising at least one suspended portion and a fluid channel (2) defined between said substrate and a cover (6), said fluid channel (2) comprising two lateral walls (6.1) and an upper wall (6.2) connecting the two lateral walls (6.1) formed by said cover and a lower wall formed by said substrate and at least two openings in order to provide a circulation in said channel, said microelectronic and/or nanoelectronic structure being located inside the fluid channel, at least one electrical connection line (8) extending between said microelectronic and/or nanoelectronic structure and the outside of the fluid channel (2), said electrical connection line (8) being carried out on the substrate (4) and passing under one of the lateral walls (6.1), said device further comprising an intermediate layer (20) comprising a face in contact with base faces of said lateral walls (6.1), said face of the intermediate layer having an aptitude for sealing with the base faces, said connection line (8) being covered by said intermediate layer (20) at least immediately above the base face of said lateral wall (6.1), said lateral walls (6.1) being sealingly fixed on said substrate (4) by sealing on said intermediate layer (20).

2. Device according to claim 1, comprising a functionalisation layer (24, 224) encapsulating at least one portion of the suspended portion of the microelectronic and/or nanoelectronic structure, the functionalisation layer (24, 224) advantageously comprising one or several materials chosen from among organic or inorganic materials, polymers, oxides, semiconductors.

3. Device according to claim 1 or 2, comprising at least one pair of electrical connection lines (8) extending laterally on either side of the microelectronic and/or nanoelectronic structure and each passing under a lateral wall (6.1).

4. Device according to the claim 1, 2 or 3, wherein the intermediate layer (20) covers, in the fluid channel (2), the entire microelectronic and/or nanoelectronic structure except for its suspended portion.

5. Device according to one of claims 1 to 4, comprising electrical connection lines (8) and contact pads (9), said contact pads (9) being located outside of the fluid channel (2), said electrical connection lines (8) extending between the microelectronic and/or nanoelectronic structure and the contact pads (9).

6. Device according to one of claims 1 to 5, wherein the electrical connection lines (8) comprise several levels of metallisation at least inside the fluid channel.

7. Device according to one of claims 1 to 6, comprising a dry film for sealing (22) inserted between the intermediate layer (20) and the base faces of the lateral walls (6.1) of the cover, the dry film for sealing (22) being advantageously structured into several beads on interfaces between the intermediate layer and the base faces of the lateral walls.

8. Device according to one of claims 1 to 7, comprising at least one layer of material inserted between the intermediate layer (20) and the base faces of the lateral walls (6.1) creating a eutectic sealing or by thermo-compression, or by screen printing or wherein the sealing is a molecular sealing or wherein the sealing is made by glass frit.

9. Device according to one of claims 1 to 8, wherein the intermediate layer (20) comprises a first layer (35) of electrical insulating material in contact with the connection line (8) and a second layer (36) deposited onto the first layer, said second layer (36) being of a material such that it is little or not sensitive to a step of releasing the microelectronic and/or nanoelectronic structure, the second layer (36) being advantageously made of Si, silicon nitride, metal or hafnium oxide.

10. Device according to one of claims 1 to 3, wherein the channel forms a gas chromatography microcolumn.

11. Method of carrying out at least one device according to one of claims 1 to 10, comprising the steps of:
a) carrying out the microelectronic and/or nanoelectronic structure on a substrate and of at least one connection line,
b) forming of the intermediate layer is such a way that it has a substantially planar free face having an opening above said at least suspended portion
c) carrying out of a cover substrate comprising a fluid channel,
d) sealing of the cover substrate on the intermediate layer in such a way that the fluid channel is arranged facing the microelectronic and/or nanoelectronic structure.

12. Method of carrying out according to claim 11, comprising a step of carrying out a functionalisation layer inside the fluid channel on the microelectronic and/or nanoelectronic structure and/or on the walls of the cover and/or on the intermediate layer said step being carried out before the sealing.

13. Method of carrying out according to claim 11 or 12, comprising after the step b), a step of releasing said microelectronic and/or nanoelectronic structure.

14. Method of carrying out according to one of the claims 11 to 13, wherein the step of sealing using a dry film, the method for carrying out comprises the sub-steps of:
- rolling of dry film on the base faces of the walls of the cover,
- structuring of the dry film,
- coming closer together of the cover and of the substrate comprising the microelectronic and/or nanoelectronic structure,
- application of a pressure in such a way as to crush the dry film, and/or wherein the sealing is a eutectic sealing or by thermo-compression, or by molecular sealing or by screen printing.

15. Method of carrying out according to one of the claims 11 to 14, wherein the carrying out of the intermediate layer takes place by deposit of a first layer of electrical insulating material and of deposit of a second layer on the first layer.

16. Method of carrying out according to one of the claims 11 to 15, wherein several devices are carried out simultaneously, said substrate comprising several microelectronic and/or nanoelectronic structures and the cover substrate comprising several covers, with the covers being sealed simultaneously on the substrate comprising the microelectronic and/or nanoelectronic structures, in such a way that a fluid channel of a device can communicate or not with the fluid channel of other devices.

17. Method of carrying out according to claim 16, comprising the steps of:
- carrying out pre-cuts in a direction perpendicular to the fluid channels in the cover substrate and in the substrate bearing the microelectronic structures and/or
- carrying out cuts or pre-cuts in a direction parallel to the fluid channels in the substrate bearing the microelectronic and/or nanoelectronic structures,
- separating devices, said separation of the devices being advantageously carried by cleavage.

18. Method of carrying out according to claim 16 ou 17, wherein the cover substrate comprising cavities formed beforehand between the channels wherein are located contact pads after sealing, the method further comprises a step of cutting the cover substrate in order to open said cavities.

19. Method of carrying out according to claim 18 wherein a functionalisation layer has been formed on said microelectronic and/or nanoelectronic structure and on the contact pads before the sealing, said method comprising the step of removing by etching of the functionalisation layer on the contact pads after sealing and opening of the cavities in the cover, said covers forming masks t said etching for the microelectronic and/or nanoelectronic structures.
